# EUROPÄISCHE PATENTSCHRIFT

(11) **EP 2 032 501 B1**
(45) Veröffentlichungstag und Bekanntmachung des Hinweises auf die Patenterteilung: **15.06.2011**
(21) Anmeldenummer: 07764841.8
(22) Anmeldetag: 25.06.2007
(51) Int. Cl.: B81C 1/00, G01L 9/00, H04R 19/04

(54) **NANOMIKROFON BZW. -DRUCKSENSOR**
NANO-MICROPHONE OR PRESSURE SENSOR
NANOMICROPHONE OU NANOCAPTEUR DE PRESSION

(30) Priorität: 23.06.2006 DE 102006028990
(43) Veröffentlichungstag der Anmeldung: 11.03.2009
(73) Patentinhaber: Universität Bielefeld, 33615 Bielefeld (DE)
(72) Erfinder: GÖLZHÄUSER, Armin, 33615 Bielefeld (DE)
(74) Vertreter: Müller-Boré & Partner Patentanwälte
(86) Internationale Anmeldenummer: PCT/EP2007/005613
(87) Internationale Veröffentlichungsnummer: WO 2007/147643

(56) Entgegenhaltungen:
- EP-A- 1 398 298
- US-A1- 2005 254 673
- GOEDEL W A ET AL: "Elastomeric suspended membranes generated via Langmuir-Blodgett transfer" LANGMUIR AMERICAN CHEM. SOC USA, Bd. 14, Nr. 13, 23. Juni 1998 (1998-06-23), Seiten 3470-3474, XP002458715 ISSN: 0743-7463
- ECK WOLFGANG ET AL: "Freestanding nanosheets from crosslinked biphenyl self-assembled monolayers" ADV MATER; ADVANCED MATERIALS NOV 4 2005, Bd. 17, Nr. 21, 4. November 2005 (2005-11-04), Seiten 2583-2587, XP002458834

## Beschreibung

Die vorliegende Erfindung betrifft eine Vorrichtung und ein Verfahren zur Messung bzw. Detektion von Drücken und/oder Druckänderungen, insbesondere akustischer Schwingungen und ein Verfahren zur Herstellung einer solchen Vorrichtung. Insbesondere betrifft die Erfindung ein Nano-Mikrofon.

Ein Kondensatormikrofon (engl. capacitor, condenser microphone) nutzt als elektrostatischer Schallwandler die Möglichkeiten der Beeinflussung elektrischer Größen durch einen Kondensator, dessen Kapazität sich dem auftreffenden Schall entsprechend ändert. Es besteht im wesentlichen aus einer vorzugsweise sehr dünnen, elektrisch leitfähigen Folie und/oder Schicht, die in einem vorzugsweise sehr kleinen Abstand vorzugsweise straff gespannt über einer elektrisch leitfähigen Gegenelektrode, vorzugsweise einer Metallplatte angebracht ist. Folie bzw. Schicht und Gegenelektrode bzw. Metallplatte bilden die Elektroden (erste und zweite Elektrode) eines Kondensators. Der eintreffende Schall bringt die Folie zum Schwingen, so dass sich zumindest bereichsweise der Abstand von Folie bzw. Schicht und Gegenelektrode bzw. Metallplatte und damit die Kapazität des Kondensators ändert. Man könnte zwischen zwei Verfahren unterscheiden, um eine Audiospannung aus der Kapazitätsänderung abzuleiten, die sich beim Niederfrequenz- und beim Hochfrequenz-Kondensatormikrofon beobachten lassen:

Das Niederfrequenz-Kondensatormikrofon (NF-Kondensatormikrofon) arbeitet vorzugsweise mit einer (relativ hohen) Spannung, die über einen hohen Widerstand auf die Elektroden des Kondensators geleitet wird. Durch die Auslenkung der Membrane (Folie) ändert sich die am Kondensator anstehende Spannung, weil die elektrische Ladung über den Widerstand nicht schnell genug abfließen kann. Die daraus resultierenden Spannungsschwankungen - das gewünschte Signal - werden aber noch nicht unmittelbar weitergeleitet. Durch den hohen Innenwiderstand des Systems ist die Signalspannung sehr klein. Vorzugsweise werden dabei ein Impedanzwandler zur Verringerung des Innenwiderstands sowie ein Verstärker nachgeschaltet. Vorzugsweise sind beide Bausteine in einem Mikrofongehäuse enthalten und werden über eine eigene Stromversorgung versorgt. Die erforderliche Betriebsspannung wird entweder von einer eingebauten Batterie geliefert oder über Mikrofonkabel zugeführt (Phantomspeisung, Tonaderspeisung).

Bei einem insbesondere einfacher aufgebauten (und daher billigeren), aber im Prinzip ähnlichen Elektretmikrofon wird die benötigte Spannung von einem Elektret abgegeben, das ist ein spezielles, vorzugsweise auf die Membran aufgetragenes, vorzugsweise elektrisch isolierendes Material, das in der Lage ist, eine elektrische Ladung über viele Jahre zu speichern und/oder das permanent oder quasipermanent gespeicherte elektrische Ladungen und/oder permanent oder quasipermanent ausgerichtete elektrische Dipole enthält und somit ein permanentes oder quasi-permanentes elektrisches. Feld in seiner Umgebung und/oder in seinem Inneren erzeugt. Vorzugsweise umfasst das Elektretmikrofon einen Verstärker, der über eine vorzugsweise im Mikrofon integrierte Stromversorgung, wie z.B. einer Batterie, versorgt wird, welche die Stromversorgung vorzugsweise über einen sehr langen Zeitraum aufrecht erhalten kann. Ein aufwendig konstruiertes Elektretmikrofon erreicht nahezu die Klangqualität eines Kondensatormikrofons.

Auch beim Hochfrequenz-Kondensatormikrofon (HF-Mikrofon) bilden eine hauchdünne Folie und eine Metallplatte einen kleinen Kondensator, der diesmal jedoch die Schwingungen eines Hochfrequenzoszillators (Oszillator) verändert. Mit einem nachgeschalteten Demodulator (Demodulation) wird die benötigte niederfrequente Signalspannung gewonnen. Da auch diese Spannung sehr klein ausfällt, sorgt wiederum ein eingebauter Verstärker mit nachgeschaltetem impedanzwandler für die notwendige Anhebung der Signalspannung. Für einen HF-Oszillator, Demodulator und Verstärker sowie zur Erzeugung der Kondensatorspannung wird eine relativ hohe Versorgungsspannung benötigt (meist 48 V), die von außen (Phantomspeisung, Tonaderspeisung) zugeführt werden muss. Das HF-Kondensatormikrofon ist in der professionellen Studiotechnik trotz hoher Beschaffungskosten der am häufigsten eingesetzte Mikrofontyp. Es besitzt ausgezeichnete Übertragungseigenschaften und genügt höchsten Qualitätsansprüchen. Zum Teil wird es mit umschaltbarer Richtcharakteristik gebaut, was durch den Einbau eines Systems mit doppelter Membran ermöglicht wird. Durch die mechanisch empfindliche Konstruktion ist dieses Mikrofon allerdings einer rauhen Behandlung (etwa als Teil einer PA-Anlage) normalerweise nicht gewachsen; bereits ein kräftiger Stoß oder ein Fall aus geringer Höhe kann die Membran zerstören.

Kondensatormikrofone werden in Transistor- und Röhrenausführung hergestellt. Röhrenmikrofone gelten als wärmer im Klang und werden je nach Klangvorstellung vor allem für Vokalaufnahmen eingesetzt.

Goedel W. A. et al.: "Elastomeric Suspended Membranes Generated via Langmuir-Blodgett Transfer" LANGMUIR AMERICAN CHEM. SOC USA, Bd. 14, Nr. 13, 23. Juni 1998, Seiten 3470-3473, offenbart eine monomolekulare Membran, die über eine Öffnung einer Messingplatte gespannt ist und durch einen Druckunterschied auf beiden Seiten der Messingplatte im Bereich der Öffnung deformiert werden kann. Eck W. et al.: "Freestanding Nanosheets from Crosslinked Biphenyl Self-Assembled Monolayers" Advanced Materials 2005, Bd. 17, Seiten 2583-2587, beschreibt ein Verfahren zur Herstellung freistehender Nanomembranen aus selbstorganisierten Monolagen. In EP 1 398 298 A2 wird ein Verfahren zur Herstellung eines Mikrofons auf Basis von monokristallinem Silizium beschrieben. US 2005/0254673 A1 beschreibt die Herstellung eines Elektretmikrofons auf Basis bekannter Technologien von mikro-elektromechanischen Systemen.

Aufgabe der Erfindung ist es, ein Verfahren und eine Vorrichtung zur Messung bzw. Detektion und/oder zur Erzeugung, d.h. Generation, von Drücken und/oder Druckänderungen, insbesondere akustischer Schwingungen mit verbesserter Sensitivität sowie ein Verfahren zur Herstellung einer solchen Vorrichtung bereitzustellen.

Diese Aufgabe wird durch eine Vorrichtung, ein Detektions- bzw. Erzeugungsverfahren und ein Herstellungsverfahren sowie Verwendungen mit den in den unabhängigen Ansprüchen angegebenen Merkmalen gelöst. Bevorzugte Ausführungsformen sind Gegenstand der abhängigen Ansprüche.

Somit betrifft die vorliegende Erfindung in einem Aspekt insbesondere eine Vorrichtung zur Messung bzw. Detektion von Drücken und/oder Druckänderungen, insbesondere akustischer Schwingungen, umfassend zumindest eine Nanomembran; und zumindest eine Gegenelektrode. Vorzugsweise weist die Nanomembran einen frei schwebenden Abschnitt bzw. Bereich bzw. Schwingungsabschnitt bzw. -bereich und einen feststehenden Abschnitt bzw. Bereich bzw. Anlageabschnitt bzw. -bereich auf. Vorzugsweise umfasst die Nanomembran ein Nanosheet bzw. eine Trägermembran. In einer weiteren Ausführungsform ist die Vorrichtung zusätzlich oder alternativ zur Erzeugung von Drücken und/oder Druckänderung, insbesondere von akustischen Schwingungen ausgefegt.

Die Trägermembran umfasst eine im wesentlichen monomolekulare Membran bzw. eine Monoschicht, insbesondere eine zumindest teilweise bzw. bereichsweise im wesentlichen in lateraler Richtung vernetzte Monoschicht, die vorzugsweise aus niedermolekularen Aromaten und/oder Heteroaromaten aufgebaut ist. In einer weiteren Ausführungsform umfasst die Trägermembran eine Graphenschicht. Bei der bevorzugten Monoschicht aus Graphen handelt es sich insbesondere um eine monomolekulare bzw. monoatomare Schicht von sp2-hybridisiertem Kohlenstoff. Insbesondere umfasst die Monoschicht somit vorzugsweise einen Graphen-Flächeneinkristall. Die monomolekulare Trägermembran betrifft insbesondere eine Membran bzw. Schicht, die in Membrandickenrichtung bzw. Membrannormalenrichtung aus nur einer Moleküllage besteht.

Durch die erfindungsgemäße Kombination der Nanomembran mit der Gegenelektrode lässt sich in besonders effizienter Weise eine Miniaturisierung der Vorrichtung erreichen, wobei durch die Ausgestaltung der Nanomembran mit einer Trägermembran, welche zumindest bereichsweise eine Monoschicht umfasst, zum einen die Sensitivität verbessert, andererseits aber auch die Stabilität der Vorrichtung gegenüber mechanischen oder thermischen Einflüssen erhöht werden kann, da sich gerade Monoschichten als einerseits besonders widerstandsfähig anderseits ausreichend sensitive für solche Anwendungen herausgestellt haben.

Vorzugsweise umfasst die Nanomembran, insbesondere der Schwingungsabschnitt der Nanomembran, zumindest eine Detektionsschicht bzw. Membranbeschichtung, die vorzugsweise an der Trägermembran angeordnet ist. Vorzugsweise ist die Gegenelektrode zumindest teilweise bzw. bereichsweise im wesentlichen parallel zur Membranebene angeordnet. Vorzugsweise ist die Detektionsschicht als erste und die Gegenelektrode als zweite Elektrode eines Kondensators ausgestaltet. Damit ist die Vorrichtung in einer bevorzugten Ausführungsform als Kondensatormikrofon ausgestaltet. Vorzugsweise ist dabei die Gegenelektrode als flächige Elektrode ausgebildet und von der Nanomembran unter Bildung einer Plattenkondensatorstruktur beabstandet. Dabei kann die Nanomembran insbesondere im Bereich des Schwingungsabschnitts relativ zur Gegenelektrode schwingen.

Vorzugsweise ist die zumindest eine Monoschicht als eine zumindest teilweise bzw. bereichsweise im wesentlichen in lateraler Richtung vernetzte Monoschicht bzw. monomolekulare Schicht aus niedermolekularen Aromaten und/oder Heteroaromaten aufgebaut ist.

Vorzugsweise umfasst die Nanomembran, insbesondere die Detektionsschicht, und/oder die Gegenelektrode elektrisch leitfähiges Material und/oder elektrisch und/oder magnetisch polarisiertes und/oder polarisierbares Material umfasst. Insbesondere umfasst die Detektionsschicht bzw. Membranbeschichtung vorzugsweise eine Metallisierungsschicht, welche vorzugsweise metallisch leitfähiges Material, insbesondere Metall umfasst. In einer anderen bevorzugten Ausführungsform ist die Trägermembran und insbesondere die Monoschicht elektrisch leitfähig und es wird beispielsweise keine zusätzliche Metallisierungsschicht angeordnet. Als elektrisch leitfähige Trägermembran wird vorzugsweise Graphen verwendet. Dadurch erreicht man eine besonders effiziente Implementierung der Nanomembran. In einer weiteren bevorzugten Ausführungsform umfasst die Detektionsschicht Elektretmaterial. Damit ist die Vorrichtung in einer bevorzugten Ausführungsform als Elektretmikrofon ausgestaltet.

Vorzugsweise weist die Nanomembran eine Dicke in einer Membrannormalenrichtung in einem Bereich von 0,3 nm bis 200 nm, vorzugsweise zwischen 1 nm und 100 nm, noch mehr bevorzugt zwischen 1 nm und 30 nm auf. Insbesondere weist die Nanomembran und/oder die Trägermembran und/oder die Detektionsschicht vorzugsweise zumindest teilweise bzw. bereichsweise eine in Membrannormalenrichtung konstante bzw. homogene Dicke auf. Vorzugsweise weist die Trägermembran eine Dicke in einer Membrannormalenrichtung in einem Bereich von 0,3 nm bis 3 nm auf. Vorzugsweise weist die Detektionsschicht eine Dicke in Membrannormalenrichtung in einem Bereich von 0,5 nm bis 200 nm, besonders bevorzugt zwischen 1 nm und 100 nm, noch mehr bevorzugt zwischen 1 nm und 50 nm und am meisten bevorzugt größer als 5 nm und/oder kleiner als 30 nm auf.

Vorzugsweise ist die Nanomembran, insbesondere der Anlageabschnitt der Nanomembran, zumindest teilweise bzw. bereichsweise an eine Membranträgerstruktur angeordnet. Besonders bevorzugt ist die Nanomembran, insbesondere der Anlageabschnitt bzw. -bereich der Nanomembran, vorzugsweise die Trägermembran zumindest teilweise bzw. bereichsweise kovalent an die Membranträgerstruktur, insbesondere an eine vorzugsweise zumindest teilweise bzw. bereichsweise im wesentlichen planare Membrananlagefläche der Membranträgerstruktur gebunden. Vorzugsweise ist in der Membranträgerstruktur eine Schwingungsausnehmung ausgebildet ist, die von der Nanomembran, zumindest teilweise überspannt ist. Insbesondere ist in der Membranträgerstruktur vorzugsweise eine Schwingungsausnehmung ausgebildet, die in einer in der Membrananlagefläche ausgebildeten Schwingungsöffungung bzw. einem Schwingungsfenster mündet, wobei die Schwingungsöffnung bzw. das Schwingungsfenster von der Nanomembran, insbesondere vom Schwingungsabschnitt der Nanomembran, zumindest teilweise überspannt bzw. bedeckt ist.

Vorzugsweise weist die Membranträgerstruktur eine im wesentlichen zur Membrananlagefläche parallele Trägerstrukturrückfläche auf. Dabei mündet die Schwingungsausnehmung der Membranträgerstruktur vorzugsweise in einem in der Trägerstrukturrückfläche ausgebildeten Rückflächenöffnung bzw. einem Rückflächenfenster: In einer bevorzugten Ausführungsform umfasst die Membranträgerstruktur Silizium.

Vorzugsweise ist die Detektionsschicht zumindest teilweise an der der Membranträgerstruktur abgewandten Seite der Trägermembran angeordnet. Vorzugsweise ist die Gegenelektrode durch eine Spacerstruktur von der Nanomembran beabstandet. Dabei wird in einer bevorzugten Ausführungsform die Spacerstruktur zumindest teilweise von der Membranträgerstruktur gebildet.

Vorzugsweise umfasst die Gegenelektrode elektrisch leitfähiges Material und/oder elektrisch und/oder magnetisch polarisiertes und/oder polarisierbares Material. Damit lässt sich eine besonders effizienter Weise eine kapazitive Kopplung zwischen der Nanomembran und der Gegenelektrode erreichen und nutzen. Vorzugsweise umfasst die Spacerstruktur elektrisch isolierendes Material. In einer bevorzugten Ausführungsform ist die Gegenelektrode zumindest teilweise bzw. bereichsweise an die Trägerstrukturrückfläche angeordnet und überspannt bzw. bedeckt die Rückflächenöffnung vorzugsweise zumindest teilweise. In einer weiteren bevorzugten Ausführungsform ist die Gegenelektrode an einem vorzugsweise elektrisch isolierenden Elektrodenträgersubstrat angeordnet. In einer weiteren bevorzugten Ausführungsform ist die Gegenelektrode als zweite Nanomembran ausgebildet.

In einer weiteren bevorzugten Ausführungsform ist die Spacerstruktur separat bzw. unabhängig von der Membranträgerstruktur ausgebildet. Insbesondere ist die Spacerstruktur vorzugsweise an der der Membranträgerstruktur abgewandten Fläche der Nanomembran, insbesondere des Anlageabschnitts, angeordnet. In einer bevorzugten Ausführungsform ist die Detektionsschicht zumindest teilweise an der der Membranträgerstruktur zugewandten Seite der Trägermembran angeordnet.

Vorzugsweise ist zumindest ein erster Anschlusskontakt vorgesehen, der mit der Nanomembran, insbesondere mit dem Schwingungsabschnitt, vorzugsweise mit der Detektionsschicht in vorzugsweise elektrischer Signalverbindung steht. Außerdem ist vorzugsweise ein zweiter Anschlusskontakt vorgesehen, der mit der Gegenelektrode in vorzugsweise elektrischer Signalverbindung steht. In einer bevorzugten Ausführungsform sind in der Gegenelektrode und/oder in der Nanomembran eine Vielzahl von Löchern, insbesondere Schalllöcher oder Durchgangslöcher, ausgebildet.

Vorzugsweise umfasst die Vorrichtung eine Ansteuer- und/oder Auswerteelektronik, welche mit der Nanomembran und/oder mit der Gegenelektrode in elektrischer Signalverbindung steht und insbesondere in und/oder an der Membranträgerstruktur angeordnet ist. Besonders bevorzugt umfasst die Membranträgerstruktur Silizium und die Ansteuer- und/oder Auswerteelektronik umfasst eine in der Membranträgerstruktur implementierte Silizium-CMOS-Schaltung.

In einer weiteren Aspekt betrifft die Erfindung ein Verfahren zur Herstellung einer Vorrichtung insbesondere zur Messung und/oder Detektion und/oder Generation von Drücken und/oder Druckänderungen, insbesondere akustischer Schwingungen, vorzugsweise zur Herstellung einer Vorrichtung nach einem der vorangegangenen Ansprüche. Das Verfahren umfasst dabei insbesondere die Schritte: Ausbilden einer Nanomembran und Anordnen einer Gegenelektrode vorzugsweise zumindest teilweise im wesentlichen parallel zur Nanomembran.

Dabei betrifft die Erfindung ein Verfahren zur Herstellung einer Vorrichtung insbesondere zur Messung und/oder Detektion und/oder Generation von Drücken und/oder Druckänderungen, insbesondere akustischer Schwingungen, vorzugsweise zur Herstellung einer Vorrichtung gemäß der vorliegenden Erfindung oder einer bevorzugten Ausführungsform davon, wobei das Verfahren umfasst:
- Anordnen einer eine monomolekulare Trägermembran umfassenden Nanomembran an eine Membranträgerstruktur derart, dass die Nanomembran eine Schwingungsausnehmung in der Membranträgerstruktur zumindest teilweise überspannt; und
- Anordnen einer von der Nanomembran beabstandeten Gegenelektrode.

In einer bevorzugten Ausführungsform umfasst die Erfindung ein Bereitstellen eines Substrats. Vorzugsweise umfasst das Verfahren ein Modifizieren der Oberfläche des Substrats. In einer weiteren bevorzugten Ausführungsform umfasst das Verfahren ein Aufbringen einer insbesondere selbstorganisierten Monoschicht (SAM) aus niedermolekularen Aromaten und/oder Heteroaromaten unter kovalenter Bindung über Ankergruppen auf einer vorzugsweise modifizierte Oberfläche des Substrats. Außerdem umfasst das Verfahren vorzugsweise ein Behandeln des mit einer Monoschicht aus niedermolekularen Aromaten und/oder Heteroaromaten versehenen Substrats mit energiereicher Strahlung derart, dass die über Ankergruppen kovalent an die Oberfläche des Substrats gebundene, aus niedermolekularen Aromaten und/oder Heteroaromaten aufgebauten Monoschicht kovalent in lateraler Richtung vernetzt wird.

Vorzugsweise umfasst das Verfahren einen Schritt des zumindest teilweisen bzw. lokalen Ablösens der insbesondere lateral vernetzten Monoschicht vom Substrat umfasst. Vorzugsweise umfasst das Ablösen der Monoschicht vom Substrat einen Schritt des Aufbrechens von chemischen Bindungen zwischen der Monoschicht und dem Substrat; und/oder einen Schritt des lokalen Abtragens des Substrats.

Das Substrat bildet und/oder umfasst dabei vorzugsweise zumindest teilweise die Membranträgerstruktur. Dabei könnte die Monoschicht unmittelbar auf die Membranträgerstruktur als Substrat aufgebracht werden oder es könnte eine Zwischenschicht bzw. Hilfsschicht zwischen der Membranträgerstruktur und der Monoschicht vorgesehen sein, die insbesondere nach dem lateralen Vernetzen der Monoschicht zumindest teilweise entfernt wird. Das Verfahren umfasst vorzugsweise ein Ausbilden der Membranträgerstruktur zumindest teilweise ausgehend vom Substrat, wobei ein Ausbilden der Schwingungsausnehmung das lokalen Abtragen des Substrats umfasst.

Vorzugsweise umfasst das Verfahren
- einen Schritt des Anordnens einer Spacerstruktur an die Nanomembran, vorzugsweise durch Kleben und/oder ein Abscheideverfahren; und/oder
- einen Schritt des Anordnens der Gegenelektrode an die Spacerstruktur, vorzugsweise durch Kleben und/oder ein Abscheideverfahren, insbesondere ein thermisches Abscheideverfahren, wie z.B. Aufdampfen; alternativ auch Sputtern.

Vorzugsweise umfasst das Verfahren:
- einen Schritt des Ausbildens bzw. Bereitstellens eines Substrats als lateral strukturierte Schichtstruktur mit eingeschlossener Metallschicht für die Gegenelektrode; und/oder
- einen Schritt des Ausbildens einer Schwingungsausnehmung im Substrat, insbesondere durch lokales Abtragen, insbesondere Ätzen, eines Bereichs der lateral strukturierten Schichtstruktur, vorzugsweise unter lokalem Freilegen der Metallschicht.

Das Substrat bildet und/oder umfasst dabei vorzugsweise zumindest teilweise die Spacerstruktur. Dabei könnte die Monoschicht unmittelbar auf die Spacerstruktur als Substrat aufgebracht werden oder es könnte eine Zwischenschicht bzw. Hilfsschicht zwischen der Spacerstruktur und der Monoschicht vorgesehen sein, die insbesondere nach dem lateralen Vernetzen der Monoschicht zumindest teilweise entfernt wird. Das Verfahren umfasst vorzugsweise ein Ausbilden der Spacerstruktur zumindest teilweise ausgehend vom Substrat, wobei ein Ausbilden der Schwingungsausnehmung das lokalen Abtragen des Substrats umfasst.

Vorzugsweise umfasst das Verfahren einen Schritt des Anordnens von elektrisch leitfähigem Material und/oder elektrisch und/oder magnetisch polarisiertem und/oder polarisierbarem Material an die Trägermembran, wobei das Anordnen vorzugsweise durch thermisches Abscheiden und/oder stromloses Abscheiden erfolgt.

In einer bevorzugten Ausführungsform umfasst das Verfahren ein Ausbilden von Schalllöchern in der Gegenelektrode und/oder in der Nanomembran, wobei das Ausbilden von Schalllöchern in der Nanomembran vorzugsweise durch lokales strahlungsinduziertes Behandeln einer Monoschicht aus niedermolekularen Aromaten und/oder Heteroaromaten nur in Bereichen außerhalb der auszubildenden Schalllöcher umfasst.

In einem weiteren Aspekt betrifft die Erfindung ein Verfahren zur Messung und/oder Detektion von Drücken und/oder Druckänderungen, insbesondere akustischer Schwingungen, umfassend:
- Anordnen einer Nanomembran, welche zumindest eine monomolekulare Trägermembran umfasst, im Bereich der zu messenden bzw. detektierenden Drücke bzw. Druckänderungen; und
- Messen bzw. Detektieren einer Auslenkung der Nanomembran.

Vorzugsweise umfasst das Verfahren:
- Anordnen einer von der Nanomembran beabstandeten Gegenelektrode;
- elektrisches Kontaktieren der Nanomembran über einen ersten Anschlusskontakt; und
- elektrisches Kontaktieren der Gegenelektrode über einen zweiten Anschlusskontakt,
wobei das Messen bzw. Detektieren einer Auslenkung der Nanomembran ein Messen bzw. Detektieren eines elektrischen Signals am ersten und/oder zweiten Anschlusskontakt umfasst. Vorzugsweise umfasst das Messen bzw. Detektieren eines elektrischen Signals ein Messen bzw. Detektieren einer Spannung und/oder eines Stroms und/oder eines Widerstands. Besonders bevorzugt umfasst das Messen bzw. Detektieren eines elektrischen Signals ein Messen bzw. Detektieren einer elektrischen Kapazität und/oder einer Änderung der elektrischen Kapazität zwischen der Nanomembran und der Gegenelektrode.

In einem weiteren Aspekt betrifft die Erfindung eine Verwendung eines Nanosheets für lokale Druck- und Geräuschmessung innerhalb einer lebender Zelle und/oder für lokale Druck- und Geräuschmessung in nanofluidischen Elementen. Dabei betrifft die Erfindung insbesondere eine Verwendung einer monomolekularen Membran, insbesondere einer lateral vernetzten Monoschicht aus niedermolekularen Aromaten und/oder Heteroaromaten und/oder einer Graphenschicht, als zumindest Teil einer Schwingungsmembran bzw. eines Diaphragmas insbesondere in einer erfindungsgemäßen Vorrichtung für insbesondere lokale Druck- und/oder Geräusch- bzw. Schallmessung innerhalb einer lebender Zelle und/oder für lokale Druck- und/oder Geräusch- bzw. Schallmessung in nanofluidischen Elementen.

Außerdem betrifft die Erfindung eine Verwendung eines Nanosheets in Druck- und/oder Geräuschsensoren in mikromechanischen Bauteilen. Dabei betrifft die Erfindung insbesondere eine Verwendung einer monomolekularen Membran, insbesondere einer lateral vernetzten Schicht aus niedermolekularen Aromaten und/oder Heteroaromaten und/oder einer Graphenschicht, als zumindest Teil einer Schwingungsmembran bzw. eines Diaphragmas in Druck- und/oder Geräuschsensoren in mikromechanischen Bauteilen.

Die Erfindung betrifft außerdem eine Verwendung eines Nanosheets in Sensoren zur Bestimmung von Windstärke und/oder Windrichtung. Dabei betrifft die Erfindung insbesondere eine Verwendung einer monomolekularen Membran, insbesondere einer lateral vernetzten Schicht aus niedermolekularen Aromaten und/oder Heteroaromaten und/oder einer Graphenschicht, als zumindest Teil einer Schwingungsmembran bzw. eines Diaphragmas in Sensoren zur Bestimmung von Windstärke und/oder Windrichtung insbesondere nach einem Verfahren gemäß der vorliegenden Erfindung oder einer bevorzugten Ausführungsform.

In einem weiteren Aspekt betrifft die Erfindung eine Verwendung eines Nanosheets in einer "akustischen Kamera", insbesondere für Anwendungen im bzw. unter Wasser, insbesondere für eine Unterwasserkamera. Die Erfindung betrifft insbesondere eine Verwendung einer monomolekularen Membran insbesondere einer lateral vernetzten Schicht aus niedermolekularen Aromaten und/oder Heteroaromaten und/oder einer Graphenschicht, als zumindest Teil einer Schwingungsmembran bzw. eines Diaphragmas insbesondere in einer erfindungsgemäßen Vorrichtung für die Anwendung im bzw. unter Wasser.

Die Erfindung wird nachfolgend mit Bezug auf begleitende Zeichnungen bevorzugter Ausführungsformen beispielhaft beschrieben. Dabei zeigen:
- Fig. 1:: einen schematischen Querschnitt einer Vorrichtung gemäß einer ersten bevorzugten Ausführungsform der vorliegenden Erfindung;
- Fig. 2:: einen schematischen Querschnitt einer Vorrichtung gemäß einer zweiten bevorzugten Ausführungsform der vorliegenden Erfindung;
- Fig. 3:: ein beispielhaftes Aromat zur Verwendung in einer Trägermembran bzw. zur Herstellung einer Trägermembran gemäß einer weiteren bevorzugten Ausführungsform der vorliegenden Erfindung
- Figs. 4A bis 4C:: einzelne Verfahrensstufen bzw. -schritte eines bevorzugten Herstellungsverfahrens;
- Figs. 5A bis 5C:: einzelne Verfahrensstufen bzw. -schritte eines weiteren bevorzugten Herstellungsverfahrens;
- Figs. 6A bis 6D:: einzelne Stadien eines Herstellungsverfahrens gemäß einer bevorzugten Ausführungsform der vorliegenden Erfindung in Querschnittsansichten;

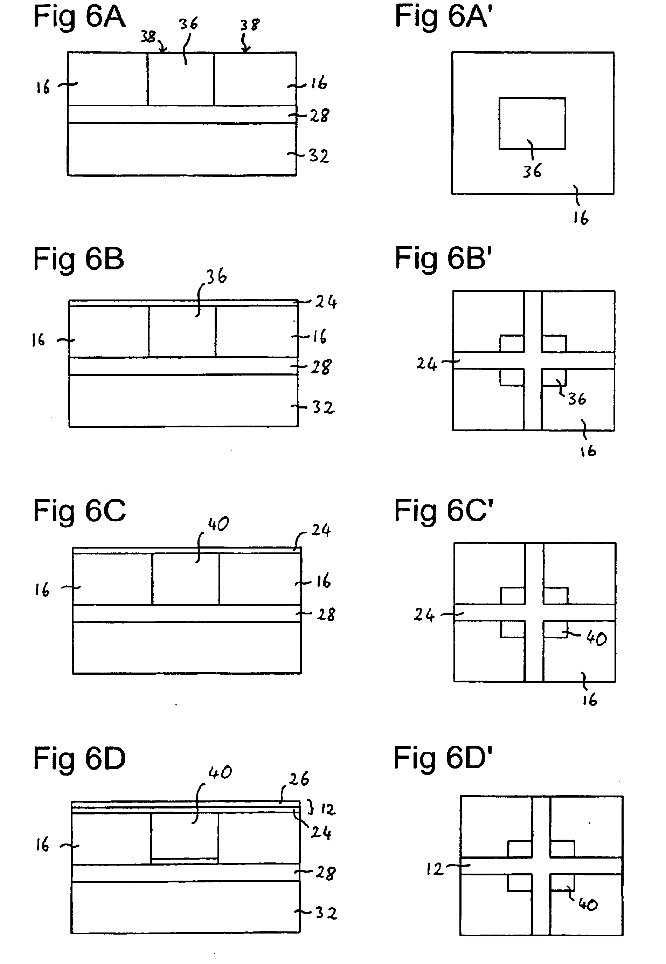

- Figs. 6A' bis 6D':: die einzelnen Stadien der Figs. 6A bis 6D jeweils in Draufsicht;

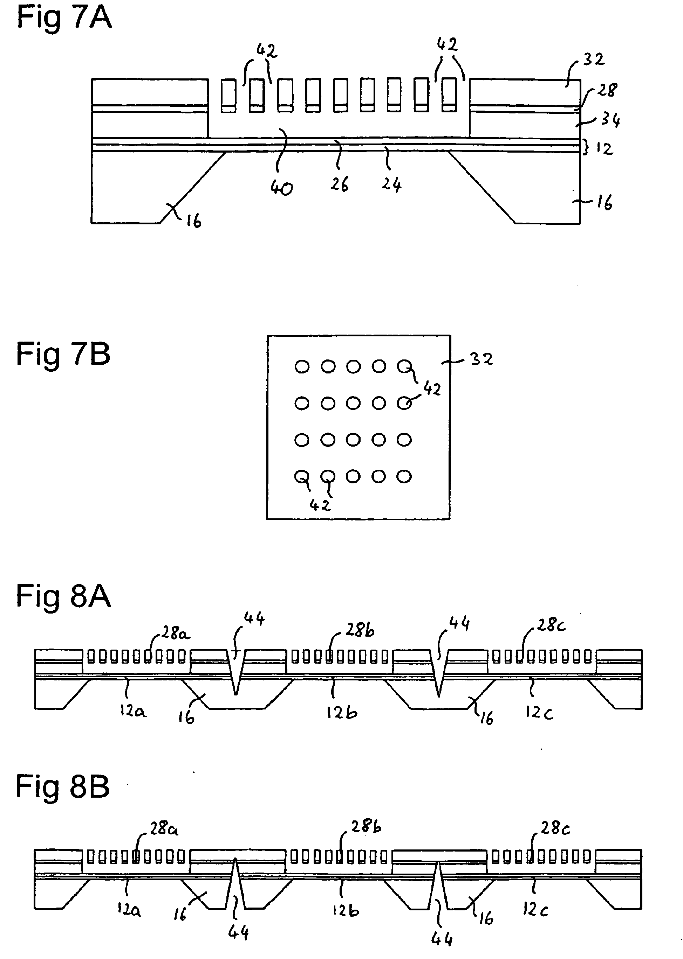

- Fig. 7:: einen schematischen Querschnitt einer Vorrichtung gemäß einer weiteren bevorzugten Ausführungsform der vorliegenden Erfindung:
- Fig. 8:: schematische Querschnitte von Kondensatormikrofonen bzw. Arrays von Kondensatormikrofonen gemäß einer weiteren bevorzugten Ausführungsform der vorliegenden Erfindung; und

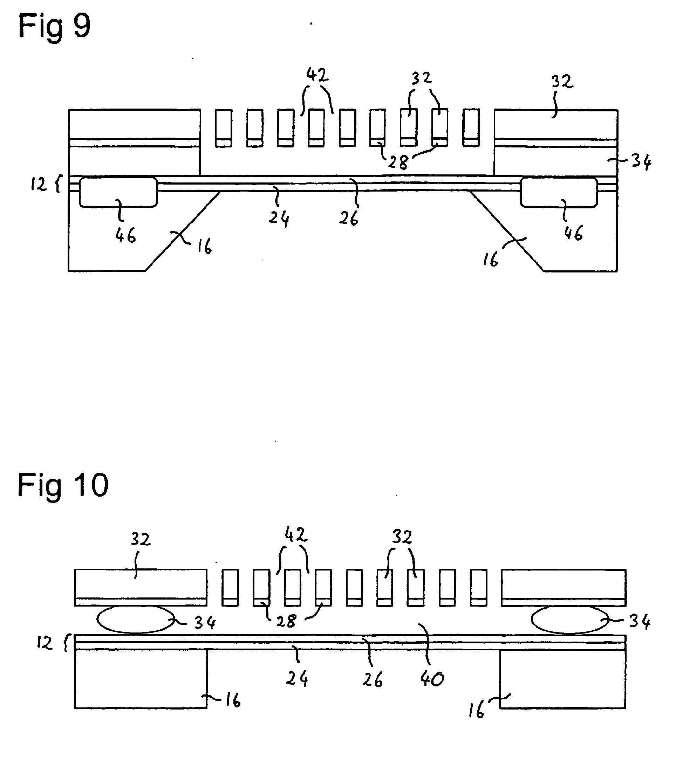

- Figs. 9 und 10:: schematische Querschnitte von Vorrichtungen gemäß weiterer bevorzugter Ausführungsformen der vorliegenden Erfindung.

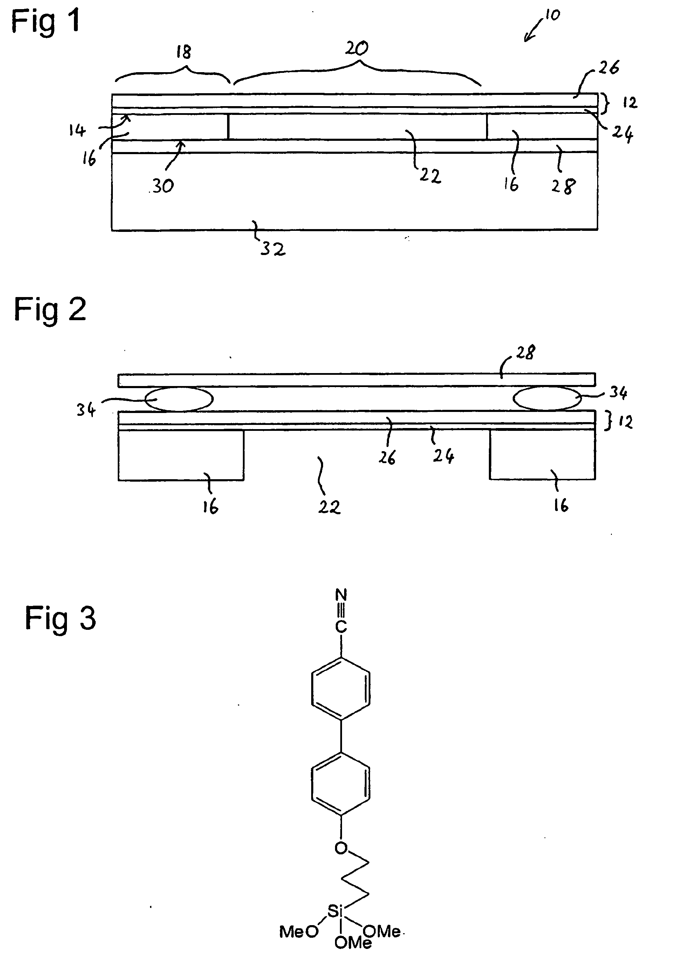

Fig. 1 zeigt einen schematischen Querschnitt einer Vorrichtung 10 zur Detektion und/oder Generation von Drücken und/oder Druckänderungen, insbesondere akustischer Schwingungen, gemäß einer ersten bevorzugten Ausführungsform der vorliegenden Erfindung. Dabei ist eine Nanomembran 12 teilweise an einer Membrananlagefläche 14 einer Membranträgerstruktur 16 angeordnet. In einer bevorzugten Ausführungsform ist die Nanomembran 12 an der Membrananlagefläche 14 zumindest teilweise kovalent an die Membranträgerstruktur 16 gebunden. In einer anderen bevorzugten Ausführungsform ist die Nanomembran 12 an der Membrananlagefläche 14 zumindest teilweise oder im wesentlichen mittels Van der Waals-Kräfte an die Membranträgerstruktur 16 gebunden.

Insbesondere umfasst die Nanomembran 12 in dem an der Membranträgerstruktur 16 angeordneten Bereich einen feststehenden Abschnitt bzw. Bereich bzw. Anlageabschnitt bzw. -bereich 18. In einem nicht an der Membranträgerstruktur 16 angeordneten Bereich umfasst die Nanomembran 12 einen frei schwebenden bzw. schwingenden Abschnitt bzw. Bereich bzw. Schwingungsabschnitt bzw. -bereich 20. In der in Fig. 1 dargestellten Ausführungsform überspannt die Nanomembran 12 und insbesondere der Schwingungsabschnitt 20 der Nanomembran 12 eine in der Membranträgerstruktur ausgebildete Schwingungsausnehmung 22.

Die Nanomembran 12 umfasst in der gezeigten bevorzugten Ausführungsform eine Trägermembran 24 und eine an der Trägermembran 24 angeordnete Detektionsschicht 26. Die Trägermembran 24 wird vorzugsweise von einer lateral vernetzen Monoschicht aus niedermolekularen Aromaten und/oder Heteroaromaten gebildet. In anderen bevorzugten Ausführungsform wird die Trägermembran 24 im wesentlichen von einer Graphenschicht gebildet. Vorzugsweise ist die Trägermembran 24 über Ankerguppen kovalent oder mittels Van der Waals-Kräfte an die Membrananlagefläche 14 der Membranträgerstruktur 16 gebunden. Die Trägermembran weist beispielsweise ein Dicke von etwa 1 nm auf. Die Detektionsschicht 26 umfasst beispielsweise Metall, wie z.B. Al, Au, Ag, Cu und/oder Ti, und weist beispielsweise eine Dicke von etwa 30 nm auf. Vorzugsweise ist die Detektionsschicht 26 mit einem ersten elektrischen Anschlusskontakt elektrisch leitfähig verbunden.

In der in Fig.1 1 dargestellten bevorzugten Ausführungsform ist die Membranträgerstruktur 16 auf einer Gegenelektrode 28 angeordnet. Vorzugsweise umfasst die Membranträgerstruktur 16 Silizium. Besonders bevorzugt ist bzw. wird die Membranträgerstruktur 16 mit der darauf angeordneten Nanomembran 12 bzw. Trägermembran 24, z.B. wie in dem genannten Artikel in Adv. Mater. 2005, über eine Trägerstrukturrückfläche 30 beispielsweise durch Klebung an der vorzugsweise planaren Gegenelektrode 28 fixiert. Die Gegenelektrode 28 umfasst vorzugsweise elektrisch leitfähiges Material, insbesondere Metall, wie z.B. Au, Ag, Al, Cr, Ti, und ist vorzugsweise mit einem zweiten elektrischen Anschlusskontakt elektrisch leitfähig verbunden. Insbesondere ist die Gegenelektrode 28 im Bereich der Schwingungsausnehmung im wesentlichen parallel zur Nanomembran 12 und insbesondere zum Schwingungsabschnitt 20 der Nanomembran 12. Die Nanomembran 12 und die Gegenelektrode bilden somit eine Kondensatorstruktur. In der in Fig. 1 dargestellten Ausführungsform ist die Gegenelektrode 28 an einem Elektrodenträgersubstrat 32 angeordnet. In dieser Ausführungsform liegt die Gegenelektrode vorzugsweise insbesondere im Bereich der Schwingungsausnehmung 22 derart flächig am Elektrodenträgersubstrat 32 an, dass die Gegenelektrode 28 im Gegensatz zur Nanomembran 12 in sich im wesentlichen nicht schwingt. Beispielsweise umfasst das Elektrodenträgersubstrat 32 Silizium.

Fig. 2 zeigt eine Vorrichtung 10 gemäß einer weiteren bevorzugten Ausführungsform der vorliegenden Erfindung. Dabei könnte die Membranträgerstruktur 24 mit der Nanomembran 12 analog zu der Ausführungsform von Fig. 1 ausgebildet sein bzw. werden. In der Ausführungsform von Fig. 2 ist allerdings die Gegenelektrode 28 nicht an der Trägerstrukturrückfläche 30 der Membranträgerstruktur 24 angeordnet, sondern über eine zusätzliche Spacerstruktur 34, welche an der der Membranträgerstruktur 16 abgewandten Fläche der Nanomembran 12 angeordnet ist, von der Nanomembran 12 beabstandet. Die Spacerstruktur 34 umfasst vorzugsweise elektrisch isolierendes Material und kann fest, wie z.B. Siliziumoxid, oder flexibel, z.B. Polymer, sein. Vorzugsweise wird die Spacerstruktur 34 mittels eines Stempelverfahrens (Nano-Imprint) am Anlageabschnitt 18 der Nanomembran 12 angeordnet. In der in Fig. 1 gezeigten Ausführungsform wird die Funktion der Spacerstruktur 34 zumindest teilweise von der Membranträgerstruktur 16 übernommen.

Ein Verfahren gemäß einer bevorzugten Ausführungsform der vorliegenden Erfindung, insbesondere zur Herstellung einer Vorrichtung gemäß der vorliegenden Erfindung oder einer bevorzugten Ausführungsform, könnte einen oder mehrere der folgenden Schritte umfassen:
(a) Bereitstellen eines Substrats;
(b) gegebenenfalls Modifizieren der Oberfläche des Substrats;
(c) Aufbringen einer Monoschicht aus niedermolekularen Aromaten und/oder Heteroaromaten unter kovalenter Bindung über Ankergruppen auf eine Oberfläche des Substrats und
(d) Behandeln des in Schritt (c) erhaltenen Substrats mit energiereicher Strahlung derart, dass die über Ankergruppen kovalent an die Oberfläche des Substrats gebundene, aus niedermolekularen Aromaten und/oder Heteroaromaten aufgebaute Monoschicht kovalent in lateraler Richtung vernetzt wird.

Fig. 3 zeigt ein bevorzugtes Aromat zur Verwendung in der vorliegenden Erfindung. Andere bevorzugte Aromate zur Verwendung in bevorzugten Ausführungsformen der vorliegenden Erfindung sind in Advanced Materials, 2005, 17, 2583 gezeigt.

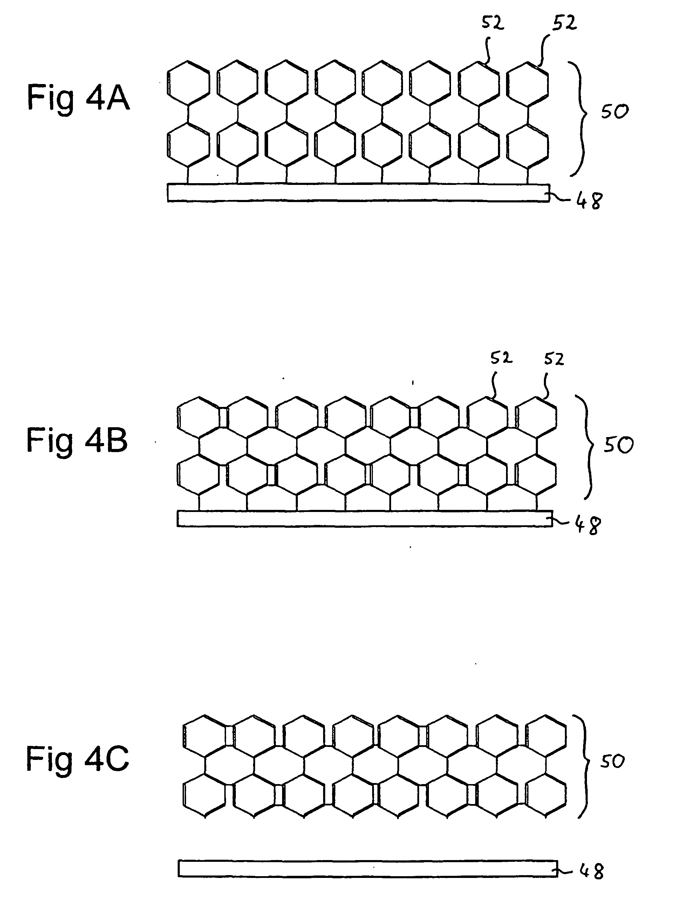

Fig. 4A bis Fig. 4C zeigen einzelne bevorzugte Verfahrensstufen während eines Ausbildens eines Nanosheets auf einem Substrat 48 und ein Ablösen des Nanosheets vom Substrat 48 gemäß einer bevorzugten Ausführungsform der Erfindung. Insbesondere zeigt Fig.4A eine vorzugsweise selbstorganisierte Monoschicht 50 (SAM) von einzelnen Aromaten 52 (aromatische Moleküle), die auf dem Substrat 48 angeordnet bzw. an das Substrat gebunden sind. Die aromatischen Moleküle 52 bilden somit eine monomolekulare Schicht 50. Wie in Fig. 4B dargestellt, werden die einzelnen Aromante 50 beispielsweise durch Elektronenbestrahlung lateral vernetzt, d.h. es bilden sich chemische Bindungen zwischen den nebeneinander angeordneten Molekülen 52 aus. Dadurch entsteht eine lateral vernetzt Monoschicht, welche vorzugsweise als Trägermembran 24 dient. Wie in Fig.4C dargestellt, wird die Monoschicht 50 anschließend vorzugsweise zumindest Teil vom Substrat 48 abgelöst, wobei eine zumindest teilweise freitragende Membran entsteht.

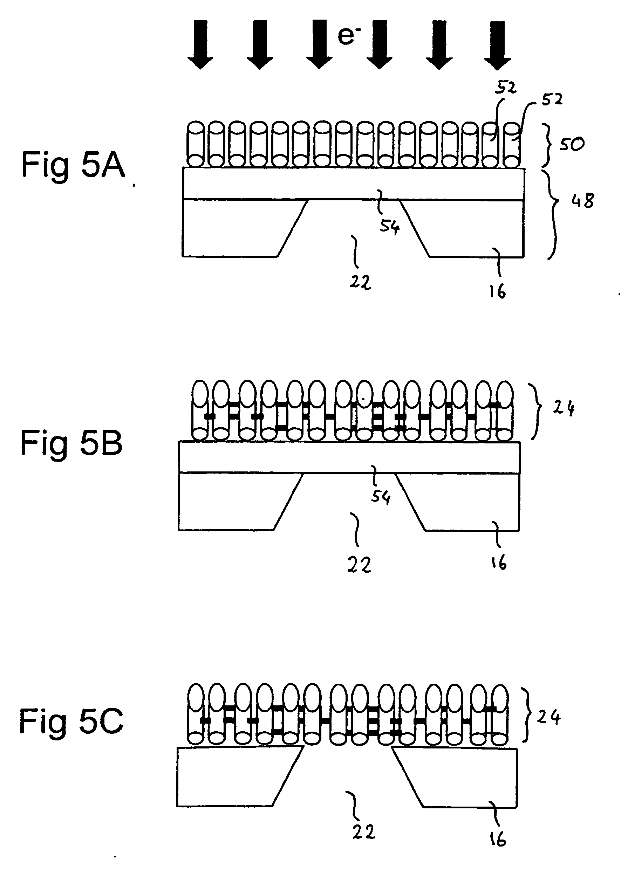

Figs. 5A bis 5C zeigen einzelne bevorzugte Verfahrensstufen während eines weiteren bevorzugten Verfahrens der vorliegenden Erfindung. Dabei fungiert vorzugsweise die mit einer Zwischenschicht bzw. Hilfsschicht 54 versehene Membranträgerstruktur 16 als Substrat 48 für das Abscheiden der Monoschicht 50 und das Ausbilden der Trägermembran 24. Vorzugsweise erfolgt das Abscheiden der Aromate 52 und das Ausbilden der lateralen Vernetzung wie in Fig. 5A und Fig. 5B dargestellt analog zu den entsprechenden in Zusammenhang mit Fig. 4 beschriebenen Verfahrensschritten. Wie in Fig. 5C dargestellt, umfasst das Ablösen der Trägermembran 24 vom Substrat 48 ein zumindest teilweises Entfernen der Zwischenschicht 54, vorzugsweise durch Ätzen mittels HF (Flusssäure). Dazu umfasst die Zwischenschicht 54 vorzugsweise SiNₓ. Damit entsteht im Bereich der in der Membranträgerstruktur 16 ausgebildeten Schwingungsausnehmung 22 eine freitragende Trägermembran, die die Schwingungsausnehmung 22 zumindest teilweise überspannt und vorzugsweise als Diaphragma für ein Kondensatormikrofone eingesetzt wird.

Vorzugsweise vernetzen die in Schritt (c) aufgebrachten Aromate 52 der Monoschicht 50 bei Behandlung mit energiereicher Strahlung, insbesondere Röntgenstrahlung, β-Strahlung, γ-Strahlung und/oder UV-Strahlung, kovalent in lateraler Richtung, so dass eine chemisch weitgehend oder völlig kovalent gebundene, dünne Monoschicht auf der Substratoberfläche entsteht. Durch die Vernetzung in lateraler Richtung erlangt die aus den niedermolekularen Aromaten und/oder Heteroaromaten aufgebaute Monoschicht vorzugsweise hohe mechanische und chemische Stabilität und schützt die darunterliegende Substratoberfläche vorzugsweise wirksam vor Beschädigung durch Reibung oder korrodierende Agentien.

In einer bevorzugten Ausführungsform des erfindungsgemäßen Verfahrens kann in Schritt (d) das Vernetzen unter lateraler Strukturierung mittels feinfokussierter ionisierender Elektronen-, Ionen- oder Photonenstrahlung durchgeführt werden. Die Fokussierung und das Rastern des Strahls über die zu strukturierenden Bereiche kann durch elektronenoptische oder ionenoptische Elemente geschehen, wie beispielsweise bei der Elektronenstrahllithographie mit Rasterelektronenmikroskopen oder der Lithographie mit fokussierten Ionen (FIB). Vorzugsweise kann die Strukturierung auch mittels Nahsondenverfahren durchgeführt werden. Die Fokussierung von Elektronen, Ionen oder Photonen ist bei diesen durch die Kleinheit der Elektronen-, Ionen- oder Photonenquelle (Nahsonde) gewährleistet. Die Nahsonde wird dann vorzugsweise in Abständen zwischen 0,1 und 1000 nm über die zu strukturierenden Bereiche geführt. Als Nahsonde für Elektronen eignen sich insbesondere die Spitzen von Rastertunnelmikroskopen (STM), Rasterkraftmikroskopen (AFM) und atomar definierte Feldemitterspitzen, die z.B. nach dem Verfahren von Müller et al. (Ultramicroscopy 50, 57 (1993)) hergestellt werden können. Letztere eignen sich besonders als Nahsonden zur Strukturierung bei größeren Abständen (> 10 nm) zwischen Sonde und Probe und können auch als Quellen für Feldionen verwendet werden. Zur Strukturierung mit Photonen eignen sich feine Spitzen aus Glas oder einem anderen photonenleitenden Material, wie sie in optischen Nahfeldmikroskopen (SNOM) verwendet werden. Bei allen Nahsondenverfahren wird die Nahsonde mittels einer Positioniereinheit, z. B. aus piezokeramischen Elementen, vorzugsweise direkt über die zu belichtenden Bereiche plaziert.

Werden in Schritt (c) anstelle einer Monoschicht aus niedermolekularen Aromaten und/oder Heteroaromaten beispielsweise gesättigte, kovalent mittels einer Ankergruppe an der Substratoberfläche gebundene Moleküle bzw. Einheiten wie Cyclohexyl, Bicyclohexyl, Tercyclohexyl, partiell oder vollständig hydrierte Naphthaline oder Anthracene oder partiell oder vollständig hydrierte Heteroaromaten aufgebracht, so kann im Wege der Behandlung mit energiereicher Strahlung im Schritt (d) neben der Vernetzung in lateraler Richtung eine Dehydrierung zu den entsprechenden Aromaten bzw. Heteroaromaten erfolgen. Wenn an der Oberfläche der aus den niedermolekularen Aromaten und/oder Heteroaromaten aufgebauten Monoschicht Nitrogruppen gebunden sind, kann in Schritt (d) der beschriebenen Verfahrens im Einwirkungsbereich der vernetzenden Strahlung auch eine Umwandlung dieser Nitrogruppen in Aminogruppen erfolgen.

In einer weiteren Ausführungsform des erfindungsgemäßen Verfahrens kann das Behandeln mit energiereicher Strahlung unter Verwendung einer Lochmaske derart durchgeführt werden, dass nur räumlich definierte Bereiche der auf der Substratoberfläche aufgebrachten Monoschicht 50 belichtet bzw. bestrahlt werden, wodurch eine strukturierte Oberfläche auf dem Substrat mit geschützten und ungeschützten Bereichen entsteht, d.h. die belichten Bereiche führen zu einer lateralen Vernetzung. Das bevorzugte oberflächenmodifizierte Schichtsystem kann somit auch als Negativresist eingesetzt werden. Insbesondere wird damit in einer bevorzugten Ausführungsform eine Strukturierung der entstehenden Trägermembran derart erreicht, dass an nicht bestrahlten Bereichen Löcher (air holes) in der Trägermembran gebildet werden, wie später noch eingehender dargestellt.

Zur Bestrahlung mit Elektronen kann eine großflächig ausleuchtende Elektronenquelle, z. B. eine "flood gun" oder ein Aufbau, wie in Abb. 2 von Hild et al., Langmuir, 14, 342-346(1998), beschrieben, verwendet werden. Dieses zitierte Dokument ist hiermit integraler Bestandteil der vorliegenden Anmeldung. Die verwendeten Elektronenenergien können dabei in einem großen Bereich, vorzugsweise 1 bis 1000 V, den jeweiligen organischen Filmen und ihren Substraten angepasst werden. Beispielsweise kann zur Vernetzung von Biphenyl-4-thiol auf Gold Elektronenstrahlung mit 50 eV verwendet werden.

Zur lateralen Strukturierung kann eine großflächig ausleuchtende Elektronenquelle in Verbindung mit einer Lochmaske verwendet werden, so dass nur die offenen Bereiche den Elektronen ausgesetzt werden. Zur lateralen Strukturierung eignen sich ebenfalls fokussierte Elektronenstrahlen, die durch ein Rasterelektronenmikroskop über die zu vernetzenden Bereichen positioniert werden können. Weiterhin können Elektronenquellen wie z. B. Feldemitterspitzen, aus der Elektronen in einen kleinen Winkelbereich emittiert werden, direkt verwendet werden, wenn sie mittels geeigneter Verstellelemente (Schrittmotoren, Piezotranslatoren) über die zu vernetzenden Bereichen positioniert werden.

Zur großflächigen Vernetzung mittels elektromagnetischer Strahlung (z.B. Röntgenstrahlung, UV-Strahlung) können im Stand der Technik verfügbare Lichtquellen verwendet werden. Zur lateralen Strukturierung bieten sich für den jeweiligen Wellenlängenbereich geeignete Masken oder das Abrastern mittels geeigneter Lichtleiter an.

Die Oberfläche des Substrats 48 kann vor dem Aufbringen der Monoschicht 50 einer Reinigung oder chemischen Modifizierung unterworfen werden. Die Reinigung kann durch einfaches Abspülen der Oberfläche mit Wasser oder organischen Lösungsmitteln wie Ethanol, Aceton oder Dimethylformamid oder durch Behandlung mit einem durch UV-Strahlung erzeugten Sauerstoff-Plasma erfolgen. Wenn die Monoschichten mit Ankergruppen wie Phosphonsäure, Carbonsäure- oder Hydroxamsäuregruppen auf oxidierten Metalloberflächen aufgebracht werden sollen, ist eine vorherige kontrollierte Oxidation der Metalloberfläche vorteilhaft. Diese kann durch Behandlung der Metalloberfläche mit oxidierenden Agentien wie Wasserstoffperoxid, Caro'scher Säure oder Salpetersäure erfolgen. Eine weitere Möglichkeit zur Modifizierung einer Substratoberfläche besteht im Aufbringen einer ersten organischen Monoschicht mit terminalen reaktiven Gruppen wie Amino-, Hydroxy-, Chlor-, Brom-, Carboxy-, oder Isocyanatgruppen, an die in einem zweiten Schritt die eigentlich zu vernetzende Monoschicht mittels geeigneter funktioneller Gruppen chemisch angekoppelt wird.

In Schritt (c) des erfindungsgemäßen Verfahrens kann das Aufbringen beispielsweise durch Tauch-, Gieß-, Spinschleuderverfahren und/oder durch Adsorption aus verdünnter Lösung durchgeführt werden.

Der mechanische Abrieb von unvernetzten Monoschichten aus einzelnen Molekülen geht schneller und in höherem Ausmaß vonstatten als bei den vernetzten Monoschichten der oberflächenmodifizierten Schichtsysteme. Ferner führt bei aliphatischen Kohlenwasserstoffketten die Behandlung mit energiereicher Strahlung zur Zerstörung der Monoschichten. Ein bevorzugtes Verfahren wird durch die nachstehenden Beispiele näher erläutert.

In einem ersten Beispiel wird eine Monoschicht von 4-Biphenylthiol auf Gold hergestellt, indem ein mit einer 100 nm dicken Goldschicht bedampfter Siliziumwafer eine Stunde lang in eine 1 mmolare ethanolische Lösung von 4-Biphenylthiol gebracht wird. Anschließend wird der Wafer herausgenommen, mehrfach mit Ethanol p.a. abgespült und im Stickstoffstrom getrocknet. Zur Vernetzung der Schichten wird der Wafer mit der Monoschicht in einer Vakuumkammer (p = 10-5 bis 10-9 mbar) mit einer "Leybold flood gun" (Typ 869000) mit Elektronen der Energie 100 eV und einer Dosis von 40.000 µC/cm2 bestrahlt. Nach dem Herausnehmen aus der Vakuumkammer kann die Schicht chemisch weiter funktionalisiert werden.

In einem weiteren Beispiel wird nach mehrfachem Reinigen einer Oberfläche von rostfreiem Stahl mit üblichen organischen Detergens-Lösungen und mehrfachem Abspülen mit entionisiertem Wasser eine Monoschicht von Terphenyl-4-phosphonsäure durch Behandeln der gereinigten Oberfläche mit einer 1 mmolaren Lösung der Terphenylphosphonsäure in Dimethylformamid hergestellt. Nach 12 Stunden ist die Monoschicht ausgebildet und das Stahlsubstrat wird je einmal mit reinem Dimethylformamid und mit entionisiertem Wasser abgespült. Danach wird die Monoschicht in gleicher Weise wie in Beispiel 1 bestrahlt und vernetzt. Die Elektronenenergie kann hierbei bis auf 200 eV angehoben werden. Zur vollständigen Vernetzung genügt eine Dosis von 30.000 µC/cm2.

In einem weiteren Beispiel wird ein Substrat aus Silizium 1 min lang in eine Mischung aus 3 Teilen 30% Wasserstoffperoxid und 1 Teil konz. Schwefelsäure gebracht. Danach wird es mit entionisiertem Wasser abgespült und in eine 1 mmolare Lösung von 4-Trichlorsilylbiphenyl in Tetrahydrofuran gebracht. Nach zwei Stunden wird das Substrat herausgenommen, mit Tetrahydrofuran abgespült, im Stickstoffstrom getrocknet und der gleichen Bestrahlungs- und Vernetzungsprozedur wie im oben genannten ersten Beispiel unterworfen. Vorzugsweise wird eine stabile und durchgängig vernetzte Oberflächenschicht erhalten.

In einem weiteren Beispiel werden analog zum oben genannten ersten Beispiel Monoschichten von 4,4>-Nitrobiphenylthiol auf einer Goldoberfläche hergestellt. Vor der Bestrahlung wird die Schicht mit einer metallischen Lochmaske abgedeckt. Nach der Bestrahlung, die wie im oben genannten ersten Beispiel durchgeführt wird, sind die Nitrogruppen an den belichteten Stellen zu Aminogruppen umgewandelt worden und die Schicht ist an diesen Stellen vernetzt. Die übrigen, von der Maske abgedeckten Bereiche der Schicht bleiben unverändert. Die durch die Bestrahlung entstandenen Aminogruppen können beispielsweise nachfolgend durch Behandlung mit einem Isocyanat, einem Säurechlorid oder Säureanhydrid aus Lösung in einem organischen Lösungsmittel wie Tetrahydrofuran oder Aceton acyliert werden.

Die durch eines dieser bevorzugten Verfahren hergestellte Monoschicht bzw. Schutzschicht bildet vorzugsweise zumindest teilweise die Trägermembran in einer bevorzugten Ausführungsform der erfindungsgemäßen Vorrichtung. Das Substrat bildet dabei vorzugsweise zumindest teilweise die Membranträgerstruktur.

Als Träger bzw. Zwischenschicht 54 bzw. Substrat kann zumindest teilweise, z.B. eine 30 nm dicke Siliziumnitridschicht eingesetzt werden, die anschließend in Fluorwasserstoff (HF, Flusssäure) zumindest teilweise und/oder bereichsweise weggeätzt wird. Die monomolekulare Membran kann durch die Anbindung von Metallpartikeln, z. B. durch Aufdampfen von Metallen oder mittels stromloser Abscheidung (wie z.B. in Dressick et al., Electrochem. Soc. 1994, 141, 210 beschrieben) mit einer elektrisch leitenden Schicht versehen werden. Der Artikel von Dressick et al., Electrochem. Soc. 1994, 141, 210 ist hiermit integraler Bestandteil der vorliegenden Anmeldung. Durch die orientierte Anbindung geladener Moleküle ist auch ein Elektret auf der Basis von Nanosheets denkbar.

Fig. 6 zeigt einzelne Schritte eines Verfahrens zur Herstellung einer Vorrichtung gemäß einer bevorzugten Ausführungsform der vorliegenden Erfindung. Dabei ist in den Figs. 6A bis 6D jeweils eine Querschnittsansicht und in den Figs. 6A' bis 6D' eine Draufsicht der Vorrichtung in den einzelnen Verfahrensstadien der Herstellung dargestellt. Wie in **Fig. 6A** gezeigt, wird beispielsweise ein Siliziumwafer als Elektrodenträgersubstrat 32 bereitgestellt, auf dem eine Metallschicht als Gegenelektrode 28 angeordnet wird. Auf der Gegenelektrode 32 wiederum wird die Membranträgerstruktur 16 mit der darin ausgebildeten Schwingungsausnehmung 22 angeordnet. Dies könnte insbesondere durch Erzeugen einer Schicht mit einer im wesentlichen homogenen Schichtdicke im Bereich von 20 nm bis 200 nm und anschließendes lithographisches Strukturieren der Schwingungsausnehmung 22 erfolgen. Die Schwingungsausnehmung erstreckt sich dabei vorzugsweise durch die gesamte Schicht der Membranträgerstruktur bis zur Gegenelektrode. In einer anderen bevorzugten Ausführungsform erstreckt sich die Schwingungsausnehmung nicht bis zur Gegenelektrode, so dass die Gegenelektrode noch vollständig bedeckt und damit passiviert bleibt.

Die Schwingungsausnehmung wird zunächst mit Stützmaterial 36 gefüllt derart gefüllt, dass dieses zusammen mit der Membranträgerstruktur eine durchgängige, vorzugsweise planare Membranabscheidefläche 38 bildet. In einer bevorzugten Ausführungsform dient die Membranabscheidefläche 38 als Substrat für die Herstellung der Trägermembran 24 bzw. des Nanosheet insbesondere gemäß einer der oben beschriebenen Herstellungsverfahren mittels strahlungsinduzierter lateraler Vernetzung.

In einer anderen bevorzugten Ausführungsform wird die Trägermembran 24 auf bzw. an einem anderen Substrat hergestellt und durch ein Schichttransferverfahren, wie es nachfolgend noch beispielhaft beschrieben wird, auf die Membranabscheidefläche 38 übertragen.

**Fig. 6B** zeigt die auf der Membranabscheidefläche 38 angeordnete Trägermembran 24. Insbesondere könnte diese durch einen Schritt des Aufbringens von aromatischem SAM (self-assembled monolayer) (z.B. Biphenyl, Terphenyl), und anschließendes lokales Vernetzen, z.B. durch e-beam oder EUV Lithographie, hergestellt werden. Nicht vernetzte Bereiche der Monoschicht (SAM) könnten anschließend entfernt werden.

Wie in **Fig. 6C** dargestellt, wird anschließend das Stützmaterial 36 wieder entfernt. Vorzugsweise umfasst das Stützmaterial SiN, das gegenüber der Membranträgerstruktur, welche vorzugsweise Si umfasst, mit hoher Selektivität beispielsweise nasschemisch geätzt werden kann, z.B. mit HF. Damit wird der Schwingungsabschnitt 20 der Trägermembran 24 freitragend bzw. freistehend.

Wie in **Fig. 6D** dargestellt, wird auf der Trägermembran 24 eine Detektionsschicht 26 angeordnet, welche vorzugsweise elektrisch leitfähiges Material und insbesondere Metall umfasst. Vorzugsweise wird die Detektionsschicht 26 durch thermische Bedampfung hergestellt. Die dabei auftretende Bedampfung des nicht durch das Nanosheet bedeckten Siliziums und des Gegenelektroden-Metalls beeinträchtigt vorzugsweise nicht die Funktion des Kondensatormikrofons. Eine Metallisierung des Nanosheet, also der Trägermembran 24, könnte durch thermische Beschichtung mit Gold erfolgen. Als bevorzugte Beschichtungsparameter könnten insbesondere eine Aufdampfzeit von 1750s (ca. 30 min) bei einer Rate von 0,17 Å/s verwendet werden. Dies führt vorzugsweise zu einer Soll-Schichtdicke von etwa 30 nm. Der Druck während des Aufdampfens liegt vorzugsweise bei etwa 4,5*10-9mbar.

Insbesondere betrifft die Erfindung die Verwendung von Nanosheets zur Messung bzw. Detektion von Drücken und/oder Druckänderungen, insbesondere akustischer Schwingungen, sowie zur Herstellung einer dazu ausgebildeten Vorrichtung, insbesondere einer Vorrichtung gemäß der vorliegenden Erfindung oder einer bevorzugten Ausführungsform.

**Fig. 7A** zeigt einen schematischen Querschnitt einer Vorrichtung gemäß einer weiteren bevorzugten Ausführungsform der vorliegenden Erfindung. Ähnlich der in Fig. 2 dargestellten Ausführungsform ist die Gegenelektrode 28 durch die Spacerstruktur 34 von der Nanomembran 12 beabstandet und bildet zusammen mit dieser eine Kondensatorstruktur, deren elektrische Kapazität bzw. Kapazitätsänderung vom Abstand bzw. dessen Änderung zwischen der Nanomembran 12 und der Gegenelektrode 28 abhängt. Durch Messung der elektrischen Kapazität lassen sich somit Schwingungen der Nanomembran 12 und damit beispielsweise Schallwellen detektieren. In einer bevorzugten Ausführungsform werden die Nanomembran 12 und die Gegenelektrode 28 mittels der Spacerstruktur 34 durch Kleben aneinander angeordnet.

Um bei einem ansonsten umschlossenen Schwingungshohlraum 40 zwischen der Nanomembran 12 und der Gegenelektrode 28 einen Druckausgleich zu ermöglichen, sind in der Gegenelektrode 28 Schwingungslöcher bzw. Schalllöcher 42 ausgebildet. In einer bevorzugten Ausführungsform werden die Schwingungslöcher 42 mittels fokussiertem Ionenstrahl (FIB) mit Durchmessern von vorzugsweise weniger als 50 nm, noch mehr bevorzugt weniger als 20 nm, am meisten bevorzugt weniger als 10 nm hergestellt. In einer weiteren bevorzugten Ausführungsform werden die Schwingungslöcher 42 mittels Elektronenstrahllithographie mit einem Durchmesser zwischen etwa 10 nm und etwa 1 µm hergestellt.

In der in Fig. 7A gezeigten Ausführungsform ist die Gegenelektrode 28 am Elektrodenträgersubstrat 32 angeordnet, wobei sich die Schwingungslöcher 42 durch die Gegenelektrode 28 und das Elektrodenträgersubstrat 32 erstrecken. Vorzugsweise bildet das Elektrodenträgersubstrat 32 evtl. zusammen mit der Gegenelektrode 28 eine perforierte Schutzkappe, welche vorzugsweise auf die Anordnung der Nanomembran 12 aufgebracht bzw. auf ihr aufgebaut wird und insbesondere als Schutz der als Diaphragma dienenden Nanomembran 12 vor Staub und/oder mechanischer Beanspruchung bzw. Beschädigung dient. Die Löcher 42 ("air holes") sorgen dabei vorzugsweise dafür, dass sich kein unerwünscht hoher Druck zwischen Nanomembran und Gegenelektrode ausbildet. Fig. 7B zeigt eine bevorzugte schematische Draufsicht auf das Elektrodenträgersubstrat 32 mit einer bevorzugten Anordnung der darin ausgebildeten Schwingungslöcher. Alternativ oder zusätzlich zur gezeigten Ausführungsform sind in einer anderen bevorzugten Ausführungsform entsprechende Schwingungslöcher in der Nanomembran 12 ausgebildet.

**Fig. 8A** und **Fig. 8B** zeigen schematische Darstellung von Vorrichtungen gemäß weiterer bevorzugter Ausführungsformen der vorliegenden Erfindung. Dabei sind vorzugsweise zwei oder mehr einzelne Mikrofonstrukturen insbesondere gemäß einer der beschriebenen Vorrichtungen gemäß einer bevorzugen Ausführungsformen der vorliegenden Erfindung regelmäßig in einem Array angeordnet. Insbesondere ist die Vielzahl von Kondensatorstrukturen vorzugsweise auf einem Wafer gefertigt. Dabei ist vorzugsweise die Membranträgerstruktur 16 aus einem Silizium-Wafer gefertigt. Vorzugsweise sind in der Vorrichtung 10 Einkerbungen 44 ausgebildet, die einerseits die Nanomembranen 12a, 12b, 12c, ... und/oder die Gegenelektroden 28a, 28b, 28c, ... der einzelnen Kondensatorstrukturen elektrisch voneinander trennen und andererseits ein Zerbrechen des Wafers und damit ein Vereinzeln der Kondensatorstrukturen zu einzelnen Nanomikrofonen erleichtern. Die Einkerbungen sind vorzugsweise keilförmig oder V-förmig ausgebildet. Dabei kann das Array vorzugsweise als Ganzes verwendet werden oder in einzelne Chips an den Einkerbungen 44 (V-grooves) gebrochen werden.

In dieser, wie auch in den anderen beschriebenen Ausführungsformen ist die Vorrichtung vorzugsweise integral mit einer Ansteuer- bzw. Ausleseelektronik für die einzelnen Kondensatorstrukturen ausgebildet. Vorzugsweise wird die Ansteuer- bzw. Ausleseelektronik in CMOS-Technologie hergestellt und die Herstellung der Kondensatorstruktur und insbesondere der Nanomembran 12 ist vorzugsweise CMOS-kompatibel. Besonders bevorzugt ist die Nanomembran sehr temperaturstabil, insbesondere zumindest bis zu einer Temperatur von etwa 1000° C. Vorzugsweise lässt sich damit die Herstellung der Nanomembran und insbesondere der monomolekularen Trägerschicht und die Herstellung einer integrierten Ansteuer- bzw. Ausleseelektronik in einen im wesentlichen gemeinsamen Prozessablauf integrieren. In einer bevorzugten Ausführungsform eignet sich die Trägerschicht insbesondere, mit piezoaktiven Materialen (Keramiken) bedampft zu werden und somit als Basis eines Nano-Mikrofons mit piezoresistiver Detektion zu fungieren.

In **Fig. 9** und **Fig. 10** sind weitere Nanomikrofone in bevorzugten Ausführungsformen dargestellt. Dabei entspricht die in Fig. 9 dargestellte Ausführungsform vorzugsweise im wesentlichen der im Zusammenhang mit Fig. 7A beschriebenen Ausführungsform, weshalb diesbezüglich auf die entsprechende Beschreibung verwiesen wird. Außerdem sind in der hier gezeigten Ausführungsform weitere Elektronikkomponenten 46 integriert, wie z.B. Source/Drain-Kontakte 46 zur Bestimmung der elektrischen Leitfähigkeit der Nanomembran und/oder des elektrischen Feldes und/oder der elektrischen Kapazität zwischen der Nanomembran 12 und der Gegenelektrode 28. Fig. 10 zeigt eine weitere Ausführungsform, bei der die Spacerstruktur analog zu der mit Bezug auf Fig. 2 beschriebenen Vorrichtung mittels eines Stempelverfahrens hergestellt und angeordnet wird.

Vorzugsweise ist ein Nanomikrofon gemäß der vorliegenden Erfindung sowohl im Niederfrequenzmodus als auch im Hochfrequenzmodus betreibbar. In einer weiteren bevorzugten Ausführungsform betrifft die Erfindung eine Vorrichtung zur Generation von Schwingungen. Insbesondere sind die beschriebenen Vorrichtungen vorzugsweise ausgelegt, in Abhängigkeit von an die Nanomembran 12 und die Gegenelektrode 28 übertragene elektrische Signale, welche insbesondere die Nanomembran gegenüber der Gegenelektrode in Schwingung versetzen, Druckänderungen und insbesondere akustische Signale zu erzeugen bzw. abzugeben.

In weiteren bevorzugten Ausführungsformen ist die Gegenelektrode als zweite Nanomembran vorzugsweise analog zur Nanomembran gemäß einer der beschriebenen Ausführungsformen ausgebildet.

Insgesamt ist die Vorrichtung 10 vorzugsweise als Kondensatormikrofon ausgestaltet. Sie umfasst vorzugsweise eine elektrisch leitfähig beschichtete, schwingungsfähige Membran 12 und eine Gegenelektrode 28. Besonders bevorzugt umfasst die schwingungsfähige Membran zumindest eine in lateraler Richtung vernetzte Monoschicht aus niedermolekularen Aromaten und/oder Heteroaromaten. Die schwingungsfähige Membran umfasst vorzugsweise orientierte elektrisch geladene Moleküle, welche besonders bevorzugt derart in und/oder an und/oder auf der Membran angeordnet sind, dass die Vorrichtung als Elektretmikrofon ausgestaltet ist.

Die Erfindung betrifft vorzugsweise ein Nano-Mikrofon. Dies ist insbesondere ein Mikrofon mit Dimensionen von wenigen Nanometern, in dem eine monomolekular Membran (Nanosheet) auf der Basis einer strahlungsvemetzten Schicht als kapazitiver Durchmesser fungiert.

Ein Nano-Mikrofon ist vorzugsweise ein nur wenige Nanometer großes, sehr empfindliches Mikrofon zum Nachweis kleinster Druckschwankungen. Der aktive Teil des Nano-Mikrofons ist eine nur 1-3 Nanometer dicke, freistehende monomolekulare Membran (Nanosheet), die durch Druckschwankungen (Schallwellen) aus ihrer Gleichgewichtslage ausgelenkt wird.

Die monomolekulare Membran (Nanosheet) basiert vorzugsweise auf einer strahlungsvernetzten Schicht, wie z.B. in DE 199 45 935 beschrieben, die, wie z.B. in Advanced Materials, 2005, 17, 2583 beschrieben, vorzugsweise von ihrem Träger abgelöst wurde. Beide Schriften (DE 199 45 935 A1 und Advanced Materials, 2005, 17, 2583) sind hiermit insbesondere im Hinblick auf die darin dargestellte strahlungsinduzierte Vernetzung von Schicht bzw. deren zumindest teilweise Ablösung von ihrem Träger integraler Bestandteil der vorliegenden Anmeldung.

Eine vorzugsweise für die Herstellung einer Nanomembran, insbesondere einer Trägermembran, welche als Nanosheet ausgebildet ist, eingesetzte Technologie wird im folgenden dargestellt. Insbesondere umfasst ein erfindungsgemäßes Verfahren vorzugsweise einen oder mehrere der folgenden Verfahrensschritte.

Insbesondere wird vorzugsweise ein oberflächenmodifiziertes Schichtsystem bereitgestellt, umfassend ein Substrat und, darauf mindestens teilweise angeordnet, eine über Ankergruppen kovalent an mindestens eine Oberfläche des Substrats gebundene, in lateraler Richtung vernetzte Monoschicht, die aus niedemnolekularen Aromaten und/oder Heteroaromaten aufgebaut ist. Als "lateral" wird hierbei vorzugsweise eine im wesentlichen zur Substratoberfläche parallele Richtung betrachtet. Vorzugsweise ist das Schichtsystem aufgrund der räumlichen Ausdehnung der über Ankergruppen kovalent an die Substratoberfläche gebundenen Moleküle, welche die in lateraler Richtung vernetzte Monoschicht aufbauen, exakt kontrollierbar bzw. einstellbar. Vorzugsweise weist die Monoschicht des oberflächenmodifizierten Schichtsystems eine Schichtdicke im Bereich von 0,3 nm bis 3 nm auf.

Die in lateraler Richtung vernetzte Monoschicht des oberflächenmodifizierten Schichtsystems ist vorzugsweise aus Aromaten, ausgewählt aus der Gruppe, bestehend aus Phenyl, Biphenyl, Terphenyl, Naphthalin und Anthracen, und/oder Heteroaromaten, ausgewählt aus der Gruppe, bestehend aus Bipyridin, Terpyridin, Thiophen, Bithienyl, Terthienyl und Pyrrol, aufgebaut.

In einer Ausführungsform der vorliegenden Erfindung kann die aus den niedermolekularen Aromaten und/oder Heteroaromaten aufgebaute Monoschicht an ihrer Oberfläche funktionelle Gruppen, ausgewählt aus Halogenatomen, Carboxy-, Trifluormethyl-, Amino-, Nitro-, Cyano-, Thiol-, Hydroxy- oder Carbonylgruppen, tragen. Die niedermolekularen Aromaten- und/oder Heteroaromatenmoleküle bzw. - einheiten, welche die Monoschicht aufbauen, sind dabei mit Hilfe einer Ankergruppe chemisch an der darunterliegenden Substratoberfläche angekoppelt bzw. an diese kovalent gebunden.

Die Vernetzung der Monoschicht in lateraler Richtung kann insbesondere durch Behandlung mit Elektronenstrahlung, Plasmastrahlung, Röntgenstrahlung, β-Strahlung, γ-Strahlung oder UV-Strahlung erzielt werden.

Vorzugsweise wird das Substrat aus der Gruppe, bestehend aus Gold, Silber, Titan, Zirkonium, Vanadium, Chrom, Mangan, Wolfram, Molybdän, Platin, Aluminium, Eisen, Stahl, Silizium, Germanium, Indiumphosphid, Galliumarsenid und Oxiden oder Legierungen oder Mischungen derselben sowie Indium-Zinn-Oxid (ITO) und Silikat- oder Boratgläsern, ausgewählt.

Wenn die Oberfläche des Substratmaterials atomar flach und homogen vorliegt, d.h. dass sie beispielsweise keine Stufenversetzungen oder Defekte aufweist, so ist vorzugsweise auch die Schutzschicht, welche vorzugsweise ein Nanosheet bzw. eine Trägermembran gemäß der Erfindung bildet, atomar flach, homogen und defektfrei und bildet eine nahezu ideal glatte Membran. Die Schutzschicht passt sich der Morphologie des Substrats vorzugsweise in nahezu idealer Weise an. Auf diese Weise lassen sich auch Objekte mit dreidimensionalen Oberflächenmorphologien mit einer vernetzten Schutzschicht definierter Dicke bedecken.

Die erfindungsgemäßen Monoschichten der oberflächenmodifizierten Schichtsysteme können auch elektrische Leitfähigkeit mittels Durchtritt von Elektronen oder Löchern zeigen. Dies ermöglicht die Nutzung der erfindungsgemäßen Monoschichten in Geräten, bei denen der Ladungsdurchtritt durch die Oberfläche durch eine stabile Schutzschicht kontrolliert werden soll, wie beispielsweise in beschichteten elektronischen Bauelementen oder Elektroden.

Die Ankergruppe, mit der die Monoschichten auf dem Substratmaterial chemisch verankert sind, ist vorzugsweise aus der Gruppe, bestehend aus Carboxy-, Thio-, Trichlorsilyl-, Trialkoxysilyl-, Phosphonat-, Hydroxamsäure- und Phosphatgruppen, ausgewählt, wobei die Ankergruppen mit Hilfe eines Abstandshalters mit einer Länge von 1 bis zu 10 Methylengruppen an die in lateraler Richtung vernetzte, aus niedermolekularen Aromaten und/oder Heteroaromaten aufgebaute Monoschicht kovalent gebunden sein können.

Die Natur der Ankergruppe ist an das jeweilige Substratmaterial anzupassen, wie es für einen Fachmann bekannt ist. Beispielsweise eignen sich für oxidierte Siliziumoberflächen insbesondere Trichlor- oder Trialkoxysilane, wie z.B. Trimethoxysilan, Triethoxysilan, etc., als Ankergruppen. Für hydrierte Silziumoberflächen können Alkoholgruppen zur Verankerung eingesetzt werden. Für Gold- und Silberoberflächen kommen z.B. Thiogruppen als Ankergruppen in Frage, für oxidierte Metalloberflächen wie Eisen oder Chrom sind Phosphonsäuren, Carbonsäuren oder Hydroxamsäuren geeignet.

In einer besonders bevorzugten Ausführungsform umfasst das oberflächenmodifizierte Schichtsystem eine aus Biphenyl-Einheiten aufgebaute Monoschicht, die über Thiogruppen als Ankergruppen an die entsprechende Substratoberfläche, wie z.B. Gold- oder Silberoberflächen, kovalent gebunden ist.

Zur Herstellung eines Nano-Mikrofons wird die vorzugsweise elektrische leitfähige Nanomembran einer Elektrode gegenübergestellt, so dass ein (miniaturisierter) Kondensator entsteht. Wird die Membran durch Druckschwankungen ausgelenkt, ändert sich die Kapazität des Kondensators und diese Druckänderung kann durch eine elektrische Spannungsänderung nachgewiesen werden.

Nano-Mikrofone können mittels Halbleiter Fabrikationsverfahren als einzelne Bauelemente herstellt werden. Aufgrund ihrer Kleinheit und dieser Fertigungsweise können sie aber auch gemeinsam mit integrierten elektrischen und mechanischen Bauelementen (NEMS) auf einem Siliziumchip herstellt werden. Somit bietet sich die Möglichkeit, integrierte Systeme herzustellen, z.B. Arrays aus Mikrofonen und den zugehörigen Empfängern und/oder Datenspeichern.

Die erfindungsgemäße Vorrichtung und insbesondere Nano-Mikrofone können vorzugsweise in einer gasförmigen Umgebung, insbesondere an Luft, und/oder in Flüssigkeit betrieben werden. Sie eignen sich vorzugsweise für folgende Anwendungen:
- Lokale Druck- und Geräuschmessung innerhalb lebender Zellen (Medizin/Biologie). Dazu ist die erfindungsgemäße Vorrichtung vorzugsweise ausgelegt, in einer flüssigen Umgebung, insbesondere in Flüssigkeit betrieben zu werden.
- Lokale Druck- und Geräuschmessung in nanofluidischen Elementen (Sensorik); für Druck- und Geräuschsensoren in mikromechanischen Bauteilen
- Sensoren zur Bestimmung von Windstärke und/oder Windrichtung vorzugsweise an verschiedenen Stellen eines umströmten Objektes. Dazu ist die erfindungsgemäße Vorrichtung vorzugsweise ausgelegt, in gasförmiger Umgebung, insbesondere an Luft, betrieben zu werden.

- Druckmessung an Stellen, in die insbesondere aus Platzgründen keine konventionellen Mikrofone passen.
- Nachweis sehr kleiner Druckänderungen, insbesondere sehr leiser Geräusche
- Arrays von Nano-Mikrofonen auf Chips eignen sich als "akustische Kameras", z. B. für Taucher

Insbesondere betrifft die Erfindung eine Vorrichtung insbesondere zur Messung bzw. Detektion von Drücken und/oder Druckänderungen, insbesondere akustischer Schwingungen, wobei die Vorrichtung zumindest eine Nanomembran und zumindest eine Gegenelektrode umfasst. Die Nanomembran liegt dabei vorzugsweise zumindest teilweise bzw. bereichsweise in bzw. an einer Ebene, der Membranebene. Richtungen parallel zu dieser Ebene sollen im folgenden als "lateral" bezeichnet werden, während die Richtung senkrecht zu dieser Membranebene als Membrannormalenrichtung bezeichnet werden soll. Vorzugsweise weist die Nanomembran einen frei schwebenden Abschnitt bzw. Bereich bzw. Schwingungsabschnitt bzw. -bereich und einen feststehenden Abschnitt bzw. Bereich bzw. Anlageabschnitt bzw. -bereich auf. Vorzugsweise erstreckt sich die Tägermembran, welche vorzugsweise zumindest einen Teil der Nanomembran bildet, sowohl in den Schwingungsabschnitt als auch in den Anlageabschnitt der Nanomembran.

Vorzugsweise wird die Detektionsschicht der Nanomembran im wesentlichen von einer Metallisierungsschicht gebildet. Die Schwingungsausnehmung der Membranträgerstruktur erstreckt sich vorzugsweise durch die Membranträgerstruktur von der Membrananlagefläche durchgängig bis zur Trägerstrukturrückfläche. Vorzugsweise grenzen die Nanomembran und/oder die Gegenelektrode direkt oder indirekt an die Spacerstruktur an.

Die Gegenelektrode könnte als zweite Nanomembran ausgebildet sein. Die zweite Nanomembran könnte in einer bevorzugten Ausführungsform entsprechend den beschriebenen bevorzugten Ausführungsformen der (ersten) Nanomembran ausgebildet sein. Sie muss dabei nicht notwendigerweise identisch zur (ersten) Nanomembran ausgebildet sein.

Somit umfasst die Vorrichtung vorzugsweise ein Nano-Mikrofon, insbesondere ein Kondensatormikrofon und/oder ein Elektretmikrofon und/oder ist vorzugsweise im wesentlichen nach Art eines Kondensatormikrofons und/oder Elektretmikrofons ausgebildet, deren Kondensatorkapazität von der Nanomembran, insbesondere der Membranbeschichtung als erste Kondensatorelektrode und der Gegenelektrode als zweite Kondensatorelektrode gebildet wird. Die Trägermembran dient dabei unter anderem zum Tragen der Detektionsschicht. Sie verleiht der Nanomembran Stabilität bei einer erforderlichen Elastizität.

Vorzugsweise wird die Nanomembran wie in Zusammenhang mit den bevorzugten Ausführungsformen der erfindungsgemäßen Vorrichtung beschrieben ausgebildet.

In einer bevorzugten Ausführungsform umfasst ein erfindungsgemäßes Verfahren ein Ablösen der Monoschicht vom Substrat. Vorzugsweise umfasst das Verfahren:
- einen Schritt des Aufbrechens von chemischen Bindungen zwischen der Monoschicht und dem Substrat; und/oder
- einen Schritt des lokalen Abtragens des Substrats.

Diese beiden Möglichkeiten sind insbesondere in Advanced Materials, 2005, 17, 2583 eingehend beschrieben. Insbesondere könnte ein Ablösen der Monoschicht durch Aufbrechen von chemischen Bindungen mit Hilfe von Iod bzw. gesättigtem loddampf erfolgen, wie in Advanced Materials, 2005, 17, 2583, (insbesondere Seite 2583, letzter Abschnitt) beschrieben. Alternativ oder zusätzlich könnte ein vorzugsweise lokales Ablösen bzw. Abtragen des Substrats beispielsweise in im wesentlichen chemischer und/oder mechanischer Weise erfolgen. Beispielsweise könnte eine lokales insbesondere selektives Ätzen des Substrats, beispielsweise mit Flusssäure (HF) erfolgen, wie Advanced Materials, 2005, 17, 2583, (insbesondere ab Seite 2585, linke Spalte, letzter Abschnitt) beschrieben.

### Bezugszeichenliste

- 10: Vorrichtung
- 12: Nanomembran
- 14: Membrananlagefläche
- 16: Membranträgerstruktur (z.B. Silizium)
- 18: Anlageabschnitt
- 20: Schwingungsabschnitt
- 22: Schwingungsausnehmung
- 24: Trägermembran
- 26: Detektionsschicht
- 28: Gegenelektrode
- 30: Trägerstrukturrückfläche
- 32: Elektrodenträgersubstrat
- 34: Spacerstruktur
- 36: Stützmaterial
- 38: Membranabscheidefläche
- 40: Schwingungshohlraum
- 42: Schwingungslöcher, Schalllöcher
- 44: Einkerbungen
- 46: Elektronikkomponenten, Kontakte
- 48: Substrat
- 50: Monoschicht
- 52: Aromate
- 54: Zwischenschicht, Hilfsschicht

## Patentansprüche

1. Vorrichtung zur Detektion und/oder Generation von Drücken und/oder Druckänderungen (10), umfassend
- zumindest eine Nanomembran (12), welche eine monomolekulare Trägermembran (24) und eine an der Trägermembran (24) angeordnete und als erste Elektrode ausgestaltete Detektionsschicht (26) umfasst; und
- zumindest eine Gegenelektrode (28), welche kapazitiv an die Nanomembran (12) koppelt.

2. Vorrichtung (10) nach Anspruch 1, wobei die zumindest eine monomolekulare Trägermembran (24) Graphen umfasst.

3. Vorrichtung (10) nach Anspruch 1, wobei die zumindest eine monomolekulare Trägermembran (24) als eine zumindest teilweise bzw. bereichsweise im wesentlichen in lateraler Richtung vernetzte monomolekulare Schicht aus niedermolekularen Aromaten und/oder Heteroaromaten aufgebaut ist.

4. Vorrichtung (10) nach einem der vorangegangenen Ansprüche, wobei die Nanomembran (12) und/oder die Gegenelektrode (28) elektrisch leitfähiges Material und/oder elektrisch und/oder magnetisch polarisiertes und/oder polarisierbares Material umfasst.

5. Vorrichtung (10) nach einem der vorangegangenen Ansprüche, wobei die Trägermembran (24) eine Dicke in einem Bereich von 0,3 nm bis 3 nm aufweist.

6. Vorrichtung nach einem der vorangegangenen Ansprüche, wobei zumindest ein erster Anschlusskontakt vorgesehen ist, der mit der Nanomembran (12), insbesondere mit einem Schwingungsabschnitt (20) der Nanomembran (12), vorzugsweise mit der Detektionsschicht (26) in vorzugsweise elektrischer Signalverbindung steht, und ein zweiter Anschlusskontakt vorgesehen ist, der mit der Gegenelektrode (28) in vorzugsweise elektrischer Signalverbindung steht.

7. Vorrichtung (10) nach einem der vorangegangenen Ansprüche, wobei die Gegenelektrode (28) als zweite Nanomembran ausgebildet ist.

8. Vorrichtung (10) nach einem der vorangegangenen Ansprüche, wobei in der Gegenelektrode (28) und/oder in der Nanomembran (12) eine Vielzahl von Löchern (42) ausgebildet ist.

9. Verfahren zur Herstellung einer Vorrichtung (10) insbesondere zur Messung und/oder Detektion und/oder Generation von Drücken und/oder Druckänderungen, insbesondere akustischer Schwingungen, umfassend:
- Anordnen einer eine monomolekulare Trägermembran (24) und eine an die Trägermembran (24) angeordnete und als erste Elektrode ausgestaltete Detektionsschicht (26) umfassenden Nanomembran (12) an eine Membranträgerstruktur (16) derart, dass die Nanomembran (12) eine Schwingungsausnehmung (22) in der Membranträgerstruktur (16) zumindest teilweise überspannt; und
- Anordnen einer von der Nanomembran (12) beabstandeten Gegenelektrode (28), welche kapazitiv an die Nanomembran (12) koppelt.

10. Verfahren nach Anspruch 9, welches einen oder mehrere der folgenden Schritte umfasst:
- Bereitstellen eines Substrats (48),
- Modifizieren einer Oberfläche des Substrats (48);
- Aufbringen einer Monoschicht (50) aus niedermolekularen Aromaten und/oder Heteroaromaten (52) unter kovalenter Bindung über Ankergruppen auf der Oberfläche des Substrats (48), und/oder
- Behandeln des mit der Monoschicht (50) aus niedermolekularen Aromaten und/oder Heteroaromaten (52) versehenen Substrats (48) mit energiereicher Strahlung derart, dass die über Ankergruppen kovalent an die Oberfläche des Substrats (48) gebundene, aus niedermolekularen Aromaten und/oder Heteroaromaten (52) aufgebauten Monoschicht (50) unter Bildung der monomolekularen Trägermembran (24) kovalent in lateraler Richtung vernetzt wird.

11. Verfahren nach einem der Ansprüche 9 oder 10, welches einen Schritt des zumindest teilweisen bzw. lokalen Ablösens der monomolekularen Trägermembran (24) vom Substrat (48) umfasst.

12. Verfahren zur Messung und/oder Detektion von Drücken und/oder Druckänderungen, insbesondere, akustischer Schwingungen, umfassend:
- Anordnen einer Nanomembran (12), welche zumindest eine monomolekulare Trägermembran (24) und eine an die Trägermembran (24) angeordnete und als erste Elektrode ausgestaltete Detektionsschicht (26) umfasst, im Bereich der zu messenden bzw. detektierenden Drücke bzw. Druckänderungen;
- Anordnen einer von der Nanomembran (12) beabstandeten Gegenelektrode (28), welche kapazitiv an die Nanomembran (12) koppelt;
- Messen bzw. Detektieren einer Auslenkung der Nanomembran (12) wobei das Messen bzw. Detektieren einer Auslenkung der Nanomembran (12) ein Messen bzw. Detektieren eines elektrischen Signals an einem ersten und/oder einem zweiten Anschlusskontakt umfasst, wobei der erste Anschlusskontakt die Nanomembran und der zweite Anschlusskontakt die Gegenelektrode elektrisch kontaktiert.

13. Verwendung einer monomolekularen Membran (24) als zumindest Teil einer Schwingungsmembran (12) in einer Vorrichtung nach einem der Ansprüche 1 bis 8 für Druck- und/oder Schallmessung innerhalb einer lebender Zelle und/oder für lokale Druck- und/oder Schallmessung in nanofluidischen Elementen und/oder für die Anwendung im bzw. unter Wasser.

14. Verwendung einer monomolekularen Membran (24) als zumindest Teil einer Schwingungsmembran (12) in Druck- und/oder Geräuschsensoren in mikromechanischen Bauteilen und/oder in Sensoren zur Bestimmung von Windstärke und/oder Windrichtung nach einem Verfahren gemäß Anspruch 12.

## Claims

1. An apparatus for the detection and/or generation of pressures and/or pressure changes (10), comprising:
- at least one nanomembrane (12), which comprises a monomolecular support membrane (24) and a detection layer (26) arranged on the support membrane (24) and designed as a first electrode; and
- at least one counter electrode (28), which capacitively couples to the nanomembrane (12).

2. The apparatus (10) according to claim 1, wherein the at least one monomolecular support membrane (24) comprises graphs.

3. The apparatus (10) according to claim 1, wherein the at least one monomolecular support membrane (24) is constructed as a monomolecular layer of low-molecular-weight aromatics and/or heteroaromatics, which layer is crosslinked substantially in the lateral direction at least partially or in some area(s).

4. The apparatus (10) according to one of the preceding claims, wherein the nanomembrane (12) and/or the counter electrode (28) comprise(s) electrically conductive material and/or electrically and/or magnetically polarized and/or polarizable material.

5. The apparatus (10) according to one of the preceding claims, wherein the support membrane (24) has a thickness in a range from 0.3 nm to 3 nm.

6. The apparatus according to one of the preceding claims, wherein at least a first terminal contact is provided, which is in a preferably electrical signal communication with the nanomembrane (12), in particular with an oscillation portion (20) of the nanomembrane (12), preferably with the detection layer (26), and a second terminal contact is provided, which is in a preferably electrical signal communication with the counter electrode (28).

7. The apparatus (10) according to one of the preceding claims, wherein the counter electrode (28) is formed as a second nanomembrane.

8. The apparatus (10) according to one of the preceding claims, wherein a multitude of holes (42) is formed in the counter electrode (28) and/or in the nanomembrane (12).

9. A method for the production of an apparatus (10) in particular for the measurement and/or detection and/or generation of pressures and/or pressure changes, in particular of acoustic oscillations, comprising:
- arranging a nanomembrane (12), which comprises a monomolecular support membrane (24) and a detection layer (26) arranged on the support membrane (24) and designed as a first electrode, on a membrane support structure (16) such that the nanomembrane (12) spans an oscillation recess (22) in the membrane support structure (16) at least partially; and
- arranging a counter electrode (28) spaced from the nanomembrane (12), which capacitively couples to the nanomembrane (12).

10. The method according to claim 9, which comprises one or more of the following steps:
- providing a substrate (48),
- modifying a surface of the substrate (48);
- applying a monolayer (50) of low-molecular-weight aromatics and/or heteroaromatics (52) to the surface of the substrate (48) by covalent bonding via anchor groups, and/or
- treating the substrate (48), which is provided with the monolayer (50) of low-molecular-weight aromatics and/or heteroaromatics (52), with high-energy radiation such that the monolayer (50) of low-molecular-weight aromatics and/or heteroaromatics (52), which is covalently bonded to the surface of the substrate (48) via anchor groups, is covalently crosslinked in the lateral direction thus forming the monomolecular support membrane (24).

11. The method according to one of claims 9 or 10, which comprises a step of at least partially or locally detaching the monomolecular support membrane (24) from the substrate (48).

12. A method for the measurement and/or detection of pressures and/or pressure changes, in particular of acoustic oscillations, comprising:
- arranging a nanomembrane (12), which comprises at least one monomolecular support membrane (24) and a detection layer (26) arranged on the support membrane (24) and designed as a first electrode, in the area of the pressures or pressure changes to be measured or detected;
- arranging a counter electrode (28) spaced from the nanomembrane (12), which capacitively couples to the nanomembrane (12);
- measuring or detecting a deflection of the nanomembrane (12), wherein measuring or detecting a deflection of the nanomembrane (12) comprises measuring or detecting an electric signal on a first and/or a second terminal contact, wherein the first terminal contact electrically contacts the nanomembrane, and the second terminal contact the counter electrode.

13. A use of a monomolecular support membrane (24) as at least part of an oscillation membrane (12) in an apparatus according to one of claims 1 to 8 for the pressure and/or sound measurement within a living cell and/or for the local pressure and/or sound measurement in nanofluidic elements and/or for the application in or under water.

14. A use of a monomolecular support membrane (24) as at least part of an oscillation membrane (12) in pressure and/or noise sensors in micromechanical components and/or in sensors for the determination of a wind force and/or wind direction according to a method of claim 12.

## Revendications

1. Dispositif pour la détection et/ou la génération de pressions et/ou de changements de pression (10), comprenant
- au moins une nanomembrane (12) qui comprend une membrane support monomoléculaire (24) et une couche de détection (26) disposée sur la membrane support (24) et réalisée en tant que première électrode ; et
- au moins une électrode conjuguée (28) qui se raccorde de manière capacitive à la nanomembrane (12).

2. Dispositif (10) selon la revendication 1, dans lequel l'au moins une membrane support monomoléculaire (24) comprend des graphes.

3. Dispositif (10) selon la revendication 1, dans lequel l'au moins une membrane support monomoléculaire (24) est construite en tant que couche monomoléculaire de composés aromatiques et/ou hétéroaromatiques de faible poids moléculaire, réticulée au moins partiellement ou par zone essentiellement dans la direction latérale.

4. Dispositif (10) selon l'une quelconque des revendications précédentes, dans lequel la nanomembrane (12) et/ou l'électrode conjuguée (28) comprend du matériau électriquement conducteur et/ou du matériau électriquement et/ou magnétiquement polarisé et/ou polarisable.

5. Dispositif (10) selon l'une quelconque des revendications précédentes, dans lequel la membrane support (24) présente une épaisseur dans une plage de 0,3 nm à 3 nm.

6. Dispositif selon l'une quelconque des revendications précédentes, dans lequel au moins un premier contact de raccordement est prévu, lequel est en relation de signaux de préférence électrique avec la nanomembrane (12), notamment avec une section d'oscillation (20) de la nanomembrane (12), de préférence avec la couche de détection (26), et un second contact de raccordement est prévu, lequel est en relation de signaux de préférence électrique avec l'électrode conjuguée (28).

7. Dispositif (10) selon l'une quelconque des revendications précédentes, dans lequel l'électrode conjuguée (28) est réalisée en tant que seconde nanomembrane.

8. Dispositif (10) selon l'une quelconque des revendications précédentes, dans lequel une pluralité d'orifices (42) est réalisée dans l'électrode conjuguée (28) et/ou dans la nanomembrane (12).

9. Procédé de fabrication d'un dispositif (10) notamment pour la mesure et/ou la détection et/ou la génération de pressions et/ou de changements de pression, notamment d'oscillations acoustiques, comprenant :
- la disposition d'une nanomembrane (12) comprenant une membrane support monomoléculaire (24) et une couche de détection (26) disposée sur la membrane support (24) et réalisée en tant que première électrode sur une structure support de membrane (16), de telle sorte que la nanomembrane (12) recouvre au moins partiellement un évidement d'oscillation (22) dans la structure support de membrane (16) ; et
- la disposition d'une électrode conjuguée (28) écartée de la nanomembrane (12) qui se raccorde de manière capacitive à la nanomembrane (12).

10. Procédé selon la revendication 9, qui comprend une ou plusieurs des étapes suivantes :
- préparation d'un substrat (48),
- modification d'une surface du substrat (48) ;
- application d'une monocouche (50) de composés aromatiques et/ou hétéroaromatiques à faible poids moléculaire (52) avec liaison covalente par le biais de radicaux actifs à la surface du substrat (48), et/ou
- traitement du substrat (48) pourvu de la monocouche (50) de composés aromatiques et/ou hétéroaromatiques à faible poids moléculaire (52) avec un rayonnement de haute énergie, de telle sorte que la monocouche (50) construite à partir de composés aromatiques et/ou hétéroaromatiques à faible poids moléculaire (52), liée par covalence par le biais de radicaux actifs à la surface du substrat (48) est réticulée par covalence dans la direction latérale en formant la membrane support monomoléculaire (24).

11. Procédé selon l'une quelconque des revendications 9 ou 10, qui comprend une étape de dissolution au moins partielle ou locale de la membrane support monomoléculaire (24) du substrat (48).

12. Procédé de mesure et/ou de détection de pressions et/ou de changements de pression, notamment d'oscillations acoustiques, comprenant :
- la disposition d'une nanomembrane (12) qui comprend au moins une membrane support monomoléculaire (24) et une couche de détection (26) disposée sur la membrane support (24) et réalisée en tant que première électrode dans la région des pressions ou changements de pression à mesurer ou détecter ;
- la disposition d'une électrode conjuguée (28) écartée de la nanomembrane (12) qui se raccorde de manière capacitive à la nanomembrane (12) ;
- la mesure ou la détection d'une déviation de la nanomembrane (12), dans lequel la mesure ou la détection d'une déviation de la nanomembrane (12) comprend une mesure ou une détection d'un signal électrique au niveau d'un premier et/ou d'un second contact de raccordement, dans lequel le premier contact de raccordement vient en contact électrique avec la nanomembrane et le second contact de raccordement avec l'électrode conjuguée.

13. Utilisation d'une membrane monomoléculaire (24) en tant qu'au moins une partie d'une membrane d'oscillation (12) dans un dispositif selon l'une quelconque des revendications 1 à 8 pour la mesure de pression et/ou de bruit au sein d'une cellule vivante et/ou pour la mesure locale de pression et/ou de bruit dans des éléments nanofluidiques et/ou pour l'application dans ou sous l'eau.

14. Utilisation d'une membrane monomoléculaire (24) en tant qu'au moins une partie d'une membrane d'oscillation (12) dans des capteurs de pression et/ou de bruit dans des composants micromécaniques et/ou dans des capteurs pour la détermination de la force du vent et/ou de la direction du vent selon un procédé selon la revendication 12.
